# EUROPÄISCHE PATENTSCHRIFT

(11) **EP 1 135 219 B1**
(45) Veröffentlichungstag und Bekanntmachung des Hinweises auf die Patenterteilung: **28.01.2004**
(21) Anmeldenummer: 99953888.7
(22) Anmeldetag: 20.10.1999
(51) Int. Cl.: B05D 3/00, B05D 3/14, B05D 3/06, C23C 16/48

(54) **VERFAHREN ZUR HERSTELLUNG HAFTFESTER OBERFLÄCHENBESCHICHTUNGEN**
METHOD FOR PRODUCING ADHESIVE SURFACE COATINGS
PROCEDE POUR REALISER DES REVETEMENTS SUPERFICIELS ADHESIFS

(30) Priorität: 28.10.1998 CH 217898; 14.12.1998 CH 247398
(43) Veröffentlichungstag der Anmeldung: 26.09.2001
(73) Patentinhaber: Ciba Specialty Chemicals Holding Inc., 4057 Basel (CH)
(72) Erfinder: BAUER, Michael, D-79299 Wittnau (DE); KÖHLER, Manfred, D-79108 Freiburg (DE); KUNZ, Martin, D-79588 Efringen-Kirchen (DE); MISEV, Ljubomir, CH-4226 Breitenbach (CH)
(86) Internationale Anmeldenummer: PCT/EP1999/007942
(87) Internationale Veröffentlichungsnummer: WO 2000/024527

(56) Entgegenhaltungen:
- EP-A- 0 575 798

## Beschreibung

Die Erfindung betrifft ein Verfahren zur Herstellung gut haftender Beschichtungen auf anorganischen oder organischen Substraten. Weitere Gegenstände der Erfindung sind die Verwendung von Photoinitiatoren mit mindestens einer ethylenisch ungesättigten Gruppe zur Herstellung solcher Schichten sowie die haftfesten Beschichtungen selbst.

Die Haftung von Lackierungen, Beschichtungen oder metallischen Schichten auf anorganischen oder organischen Substraten, insbesondere auf unpolaren Substraten wie Polyethylen, Polypropylen oder fluorhaltigen Polyolefinen, wie sie unter dem Handelsnamen Teflon® bekannt sind, ist häufig nicht ausreichend, so dass zusätzliche Beschichtungsmassnahmen getroffen werden müssen, um zu zufriedenstellenden Ergebnissen zu kommen. Eine Möglichkeit besteht darin, zunächst spezielle Grundierungslacke, sogenannte Primer, aufzubringen und auf diese dann erst die gewünschte Beschichtung aufzubringen.

Eine weitere Möglichkeit besteht darin, die zu beschichtenden Substrate einer Plasma- oder Coronabehandlung auszusetzen und danach zu beschichten, wobei dazwischen noch ein Pfropfprozess mit z. B. Acrylat Monomeren liegen kann (J. Polym. Sci. , Part A: Polym. Chem. 31, 1307-1314 (1993).

Die Erzeugung von Niedertemperatur-Plasmen und die plasmaunterstützte Abscheidung dünner organischer oder anorganischer Schichten sind seit längerem bekannt und beispielsweise von A. T. Bell, "Fundamentals of Plasma Chemistry" in "Technology and Application of Plasma Chemistry", herausgegeben von J. R. Holahan und A. T. Bell, Wiley, New York (1974) oder von H. Suhr, Plasma Chem. Plasma Process 3(1),1, (1983) beschrieben.

Es ist auch bekannt, dass beispielsweise Kunststoffoberflächen einer Plasmabehandlung unterzogen werden können und dadurch die nachfolgende Lackierung eine bessere Haftung zum Kunststoffsubstrat aufweist. H. J. Jacobasch et al. beschreiben dies in Farbe + Lack 99(7), 602-607 (1993) für Niedertemperatur-Plasmen unter Vakuumbedingungen und J. Friedrich et al. in Surf. Coat. Technol. 59, 371-6(1993) für Plasmen unter Vakuum bis zu Normaldruckbedingungen, wobei das Niedertemperatur-Plasma in eine Corona-Entladung übergeht.

Es wurde nun gefunden, dass man besonders gut haftende Beschichtungen mit photohärtbaren Lacken dadurch erreichen kann, dass man einen Photoinitiator, welcher mindestens eine ethylenisch ungesättigte Gruppe aufweist auf das zu beschichtende Substrat aufpfropft, das derart gepfropfte Substrat mit einer photohärtbaren Lackschicht versieht und diese härtet. Die erhaltenen Beschichtungen weisen eine überraschend gute Haftung auf, die auch nach mehrtägiger Lagerung bzw. Belichtung am Sonnenlicht keine nennenswerte Verschlechterung aufweist.

Das Verfahren lässt sich einfach durchführen und erlaubt einen hohen Durchsatz pro Zeiteinheit, da keine langwierigen Trocknungsschritte oder langsamen Vernetzungsreaktionen notwendig sind. Das Verfahren ist besonders gut geeignet für Werkstücke, welche aus verschiedenen Kunststoffen und/oder Metallen bzw. Gläsern zusammengesetzt sind und daher ohne Vorbehandlung unterschiedliche Haftungen an den verschiedenen Teilen aufweisen würden, bzw. die bei einer herkömmlichen Primerbehandlung unterschiedliche Affinitäten zu dem Grundierungsmittel zeigen.

Ein Gegenstand der Erfindung ist ein Verfahren zur Herstellung haftfester Beschichtungen auf einem anorganischen oder organischen Substrat, dadurch gekennzeichnet, dass man in einem ersten Schritt
a) auf das anorganische oder organische Substrat eine Niedertemperatur-Plasmaentladung, eine Corona-Entladung, energiereiche UV-Strahlung oder Elektronenstrahlung einwirken lässt, anschliessend die Strahlung oder Entladung abschaltet, in einem weiteren Schritt
b) einen oder mehrere Photoinitiatoren, enthaltend mindestens eine ethylenisch ungesättigte Gruppe, unter Vakuum oder bei Normaldruck auf das anorganische oder organische Substrat aufbringt und mit den dort entstandenen Radikalstellen reagieren lässt, und
c1) das so mit Photoinitiator vorbeschichtete Substrat mit einer Zusammensetzung, enthaltend mindestens ein ethylenisch ungesättigtes Monomer oder Oligomer, beschichtet und die Beschichtung mittels UV/VIS Strahlung härtet oder
c2) auf das so mit Photoinitiator vorbeschichtete Substrat ein Metall, Halbmetall- oder Metalloxid aus der Gasphase in Gegenwart von UV-Licht abscheidet.

Möglichkeiten Plasmen unter Vakuumbedingungen zu erhalten sind vielfach in der Literatur beschrieben worden. Die elektrische Energie kann dabei auf induktivem oder kapazitivem Wege eingekoppelt werden. Es kann sich um Gleichstrom oder Wechselstrom handeln, wobei die Frequenz des Wechselstroms von wenigen kHz bis in den MHz- Bereich variieren kann. Eine Einspeisung im Mikrowellenbereich (GHz) ist ebenfalls möglich.

Die Prinzipien der Plasmaerzeugung und Aufrechterhaltung sind zum Beispiel in den vorstehend erwähnten Übersichtsartikeln von A. T. Bell und H. Suhr dargestellt.

Als primäre Plasmagase können beispielsweise He, Argon, Xenon, N₂, O₂, Wasserdampf oder Luft verwendet werden.

Das erfindungsgemässe Verfahren ist an und für sich nicht empfindlich gegenüber der Einkopplung der elektrischen Energie.

Das Verfahren kann im Batch-Betrieb, beispielsweise in einer rotierenden Trommel oder bei Folien, Fasern oder Geweben im kontinuierlichen Betrieb durchgeführt werden. Diese Verfahren sind bekannt und im Stand der Technik beschrieben.

Das Verfahren ist auch unter Corona-Entladungsbedingungen durchführbar. Corona Entladungen werden unter Normaldruckbedingungen erzeugt, wobei als ionisiertes Gas am häufigsten Luft verwendet wird. Prinzipiell sind jedoch auch andere Gase möglich, wobei dann in einem abgeschlossenen System gearbeitet werden sollte, um atmosphärische Luft fernzuhalten. Eine andere Möglichkeit besteht darin Luft als lonisierungsgas bei Corona Entladungen zu verwenden, so dass in einer nach aussen offenen Apparatur gearbeitet und zum Beispiel eine Folie zwischen den Entladungs-Elektroden kontinuierlich durchgezogen werden kann. Solche Prozessanordnungen sind bekannt und z. B. in J. Adhesion Sci. Technol. Vol 7, No. 10,1105, (1993) beschrieben. Wenn eine Corona Entladung in einer offenen Apparatur eingesetzt wird, so wird bevorzugt unter Ausschluss von Sauerstoff gearbeitet, was durch einen ausreichend grossen Inertgasfluss erreicht werden kann.

Das Verfahren ist auch unter Verwendung von energiereicher elektromagnetischer Strahlung zur Behandlung der Substrate im Vacuum oder unter Ausschluß von Sauerstoff durchführbar. Als energiereiche elektromagnetischer Strahlung kommt solche in Frage, die in der Lage ist, an der Oberfläche Radikale zu erzeugen. Beispiele sind kurzwellige UV-Strahlung oder Röntgenstrahlung. In diesem Zusammenhang sind insbesondere Elektronenstrahlen zu nennen, wie sie bereits zur Härtung von Lacken und Farben und Verklebung von Folien eingesetzt werden. Aber auch kurzweilige UV Strahlung (insbesondere Vakuum UV Strahlung), wie sie von handelsüblichen UV-Lampen oder von Excimer-Lampen erzeugt wird, ist einsetzbar. Bevorzugt handelt es sich dabei um Strahlung mit einer Wellenlänge kleiner als 300 nm, besonders bevorzugt kleiner 260 nm.

Neben konventionellen Lampen zur großflächgigen Belichtung können auch Laser, die im entsprechenden Wellenlängenbereich arbeiten, zur punktuellen Belichtungen oder zur abbildenden "Beschreibung" der Oberfläche verwendet werden. Bei Verwendung von Masken oder schreibenden Laser können auch selektiv nur bestimmte Bereiche mit Photoinitiator beladen werden, was zu unterschiedlicher Benetzung und in einer anschliessenden Beschichtung zu unterschiedlicher Haftung führt.

Die mit aufgepfropftem Photoinitiator versehenen Substrate können auch bildmässig, durch Bestrahlung durch eine Maske oder unter Verwendung von Laserstrahlen, die über die Oberfläche bewegt werden, belichtet werden, wodurch es zu einer erneuten Oberflächenmodifikation kommt, jedoch nur in den belichteten Bereichen. Damit lassen sich zum Beispiel Muster mit unterschiedlicher Hydrophobie/Hydrophilie und/oder Metallisierung erzeugen. Wird die bildmässige Belichtung in Gegenwart einer strahlenhärtenden Formulierung durchgeführt, lassen sich Muster mit beispielsweise unterschiedlicher Haftung und/oder Klebrigkeit und/oder Farbe und/oder anderen, durch die Formulierung bedingten Eigenschaften erzeugen.

Das zu behandelnde anorganische oder organische Substrat kann in beliebiger fester Form vorliegen. Bevorzugt liegt das Substrat in Form eines Pulvers, einer Faser, einer Folie oder als dreidimensionales Werkstück vor.

Bevorzugt ist das anorganische oder organische Substrat ein thermoplastisches, elastomeres, strukturvemetztes oder vemetztes Polymer, ein Metalloxid, ein Glas oder ein Metall.

Beispiele für thermoplastische, elastomere, strukturvemetzte oder vernetzte Polymere sind nachfolgend aufgeführt.
1. Polymere von Mono- und Diolefinen, beispielsweise Polypropylen, Polyisobutylen, Polybuten-1, Poly-4-methylpenten-1, Polyisopren oder Polybutadien sowie Polymerisate von Cycloolefinen wie z.B. von Cyclopenten oder Norbornen; ferner Polyethylen (das gegebenenfalls vernetzt sein kann), z.B. Polyethylen hoher Dichte (HDPE), Polyethylen hoher Dichte und hoher Molmasse (HDPE-HMW), Polyethylen hoher Dichte und ultrahoher Molmasse (HDPE-UHMW), Polyethylen mittlerer Dichte (MDPE), Polyethylen niederer Dichte (LDPE), lineares Polyethylen niederer Dichte (LLDPE), (VLDPE) und (ULDPE).
   Polyolefine, d.h. Polymere von Monoolefinen, wie sie beispielhaft im vorstehenden Absatz erwähnt sind, insbesondere Polyethylen und Polypropylen, können nach verschiedenen Verfahren hergestellt werden, insbesondere nach den folgenden Methoden:
   a) radikalisch (gewöhnlich bei hohem Druck und hoher Temperatur).
   b) mittels Katalysator, wobei der Katalysator gewöhnlich ein oder mehrere Metalle der Gruppe IVb, Vb, VIb oder VIII enthält. Diese Metalle besitzen gewöhnlich einen oder mehrere Liganden wie Oxide, Halogenide, Alkoholate, Ester, Ether, Amine, Alkyle, Alkenyle und/oder Aryle, die entweder π- oder σ-koordiniert sein können. Diese Metallkomplexe können frei oder auf Träger fixiert sein, wie beispielsweise auf aktiviertem Magnesiumchlorid, Titan(III)chlorid, Aluminiumoxid oder Siliziumoxid. Diese Katalysatoren können im Polymerisationsmedium löslich oder unlöslich sein. Die Katalysatoren können als solche in der Polymerisation aktiv sein, oder es können weitere Aktivatoren verwendet werden, wie beispielsweise Metallalkyle, Metallhydride, Metallalkylhalogenide, Metallalkyloxide oder Metallalkyloxane, wobei die Metalle Elemente der Gruppen Ia, IIa und/oder IIIa sind. Die Aktivatoren können beipielsweise mit weiteren Ester-, Ether-, Amin- oder Silylether-Gruppen modifiziert sein. Diese Katalysatorsysteme werden gewöhnlich als Phillips, Standard Oil Indiana, Ziegler (-Natta), TNZ (DuPont), Metallocen oder Single Site Katalysatoren (SSC) bezeichnet.
2. Mischungen der unter 1) genannten Polymeren, z.B. Mischungen von Polypropylen mit Polyisobutylen, Polypropylen mit Polyethylen (z.B. PP/HDPE, PP/LDPE) und Mischungen verschiedener Polyethylentypen (z.B. LDPE/HDPE).
3. Copolymere von Mono- und Diolefinen untereinander oder mit anderen Vinylmonomeren, wie z.B. Ethylen-Propylen-Copolymere, lineares Polyethylen niederer Dichte (LLDPE) und Mischungen desselben mit Polyethylen niederer Dichte (LDPE), Propylen-Buten-1-Copolymere, Propylen-Isobutylen-Copolymere, Ethylen-Buten-1-Copolymere, Ethylen-Hexen-Copolymere, Ethylen-Methylpenten-Copolymere, Ethylen-Hepten-Copolymere, Ethylen-Octen-Copolymere, Propylen-Butadien-Copolymere, Isobutylen-Isopren-Copolymere, Ethylen-Alkylacrylat-Copolymere, Ethylen-Alkylmethacrylat- Copolymere, Ethylen-Vinylacetat-Copolymere und deren Copolymere mit Kohlenstoffmonoxid, oder Ethylen-Acrylsäure-Copolymere und deren Salze (Ionomere), sowie Terpolymere von Ethylen mit Propylen und einem Dien, wie Hexadien, Dicyclopentadien oder Ethylidennorbornen; ferner Mischungen solcher Copolymere untereinander und mit unter 1) genannten Polymeren, z.B. Polypropylen/Ethylen-Propylen-Copolymere, LDPE/Ethylen-Vinylacetat-Copolymere, LDPE/Ethylen-Acrylsäure-Copolymere, LLDPE/Ethylen-Vinylacetat-Copolymere, LLDPE/Ethylen-Acrylsäure-Copolymere und alternierend oder statistisch aufgebaute Polyalkylen/Kohlenstoffmonoxid-Copolymere und deren Mischungen mit anderen Polymeren wie z.B. Polyamiden.
4. Kohlenwasserstoffharze (z.B. C₅-C₉) inklusive hydrierte Modifikationen davon (z.B. Klebrigmacherharze) und Mischungen von Polyalkylenen und Stärke.
5. Polystyrol, Poly-(p-methylstyrol), Poly-(α-methylstyrol).
6. Copolymere von Styrol oder α-Methylstyrol mit Dienen oder Acrylderivaten, wie z.B. Styrol-Butadien, Styrol-Acrylnitril, Styrol-Alkylmethacrylat, Styrol-Butadien-Alkylacrylat und -methacrylat, Styrol-Maleinsäureanhydrid, Styrol-Acrylnitril-Methylacrylat; Mischungen von hoher Schlagzähigkeit aus Styrol-Copolymeren und einem anderen Polymer, wie z.B. einem Polyacrylat, einem Dien-Polymeren oder einem Ethylen-Propylen-Dien-Terpolymeren; sowie Block-Copolymere des Styrols, wie z.B. Styrol-Butadien-Styrol, Styrol-Isopren-Styrol, Styrol-Ethylen/Butylen-Styrol oder Styrol-Ethylen/Propylen-Styrol.
7. Pfropfcopolymere von Styrol oder α-Methylstyrol, wie z.B. Styrol auf Polybutadien, Styrol auf Polybutadien-Styrol- oder Polybutadien-Acrylnitril-Copolymere, Styrol und Acrylnitril (bzw. Methacrylnitril) auf Polybutadien; Styrol, Acrylnitril und Methylmethacrylat auf Polybutadien; Styrol und Maleinsäureanhydrid auf Polybutadien; Styrol, Acrylnitril und Maleinsäureanhydrid oder Maleinsäureimid auf Polybutadien; Styrol und Maleinsäureimid auf Polybutadien, Styrol und Alkylacrylate bzw. Alkylmethacrylate auf Polybutadien, Styrol und Acrylnitril auf Ethylen-Propylen-Dien-Terpolymeren, Styrol und Acrylnitril auf Polyalkylacrylaten oder Polyalkylmethacrylaten, Styrol und Acrylnitril auf Acrylat-Butadien-Copolymeren, sowie deren Mischungen mit den unter 6) genannten Copolymeren, wie sie z.B. als sogenannte ABS-, MBS-, ASA- oder AES-Polymere bekannt sind.
8. Halogenhaltige Polymere, wie z.B. Polychloropren, Chlorkautschuk, chloriertes und bromiertes Copolymer aus Isobutylen-Isopren (Halobutylkautschuk), chloriertes oder chlorsulfoniertes Polyethylen, Copolymere von Ethylen und chloriertem Ethylen, Epichlorhydrinhomo- und -copolymere, insbesondere Polymere aus halogenhaltigen Vinylverbindungen, wie z.B. Polyvinylchlorid, Polyvinylidenchlorid, Polyvinylfluorid, Polyvinylidenfluorid; sowie deren Copolymere, wie Vinylchlorid-Vinylidenchlorid, Vinylchlorid-Vinylacetat oder Vinylidenchlorid-Vinylacetat.
9. Polymere, die sich von α,β-ungesättigten Säuren und deren Derivaten ableiten, wie Polyacrytate und Polymethacrylate, mit Butylacrylat schlagzäh modifizierte Polymethylmethacrylate, Polyacrylamide und Polyacrylnitrile.
10. Copolymere der unter 9) genannten Monomeren untereinander oder mit anderen ungesättigten Monomeren, wie z.B. Acrylnitril-Butadien-Copolymere, Acrylnitril-Alkylacrylat-Copolymere, Acrylnitril-Alkoxyalkylacrylat-Copolymere, Acrylnitril-Vinylhalogenid-Copolymere oder Acrylnitril-Alkylmethacrylat-Butadien-Terpolymere.
11. Polymere, die sich von ungesättigten Alkoholen und Aminen bzw. deren Acylderivaten oder Acetalen ableiten, wie Polyvinylalkohol, Polyvinylacetat, -stearat, -benzoat, -maleat, Polyvinylbutyral, Polyallylphthalat, Polyallylmelamin; sowie deren Copolymere mit in Punkt 1 genannten Olefinen.
12. Homo- und Copolymere von cyclischen Ethem, wie Polyalkylenglykole, Polyethylenoxyd, Polypropylenoxyd oder deren Copolymere mit Bisglycidylethern.
13. Polyacetale, wie Polyoxymethylen, sowie solche Polyoxymethylene, die Comonomere, wie z.B. Ethylenoxid, enthalten; Polyacetale, die mit thermoplastischen Polyurethanen, Acrylaten oder MBS modifiziert sind.
14. Polyphenylenoxide und -sulfide und deren Mischungen mit Styrolpolymeren oder Polyamiden.
15. Polyurethane, die sich von Polyethern, Polyestern und Polybutadienen mit endständigen Hydroxylgruppen einerseits und aliphatischen oder aromatischen Polyisocyanaten andererseits ableiten, sowie deren Vorprodukte.
16. Polyamide und Copolyamide, die sich von Diaminen und Dicarbonsäuren und/oder von Aminocarbonsäuren oder den entsprechenden Lactamen ableiten, wie Polyamid 4, Polyamid 6, Polyamid 6/6, 6/10, 6/9, 6/12, 4/6, 12/12, Polyamid 11, Polyamid 12, aromatische Polyamide ausgehend von m-Xylol, Diamin und Adipinsäure; Polyamide, hergestellt aus Hexamethylendiamin und Iso- und/oder Terephthalsäure und gegebenenfalls einem Elastomer als Modifikator, z.B. Poly-2,4,4-trimethylhexamethylenterephthalamid oder Poly-m-phenylen-isophthalamid. Block-Copolymere der vorstehend genanntenPolyamide mit Polyolefinen, Olefin-Copolymeren, lonomeren oder chemisch gebundenen oder gepfropften Elastomeren; oder mit Polyethern, wie z.B. mit Polyethylenglykol, Polypropylenglykol oder Polytetramethylenglykol. Ferner mit EPDM oder ABS modifizierte Polyamide oder Copolyamide; sowie während der Verarbeitung kondensierte Polyamide ("RIM-Polyamidsysteme").
17. Polyhamstoffe, Polyimide, Polyamid-imide, Polyetherimide, Polyesterimide, Polyhydantoine und Polybenzimidazole.
18. Polyester, die sich von Dicarbonsäuren und Dialkoholen und/oder von Hydroxycarbonsäuren oder den entsprechenden Lactonen ableiten, wie Polyethylenterephthalat, Polybutylenterephthalat, Poly-1,4-dimethylolcyclohexanterephthalat, Polyhydroxybenzoate, sowie Block-Polyether-ester, die sich von Polyethern mit Hydroxylendgruppen ableiten; ferner mit Polycarbonaten oder MBS modifizierte Polyester.
19. Polycarbonate und Polyestercarbonate.
20. Polysulfone, Polyethersulfone und Polyetherketone.
21. Vernetzte Polymere, die sich von Aldehyden einerseits und Phenolen, Harnstoff oder Melamin andererseits ableiten, wie Phenol-Formaldehyd-, Harnstoff-Formaldehyd- und Melamin-Formaldehydharze.
22. Trocknende und nicht-trocknende Alkydharze.
23. Ungesättigte Polyesterharze, die sich von Copolyestern gesättigter und ungesättigter Dicarbonsäuren mit mehrwertigen Alkoholen, sowie Vinylverbindungen als Vernetzungsmittel ableiten, wie auch deren halogenhaltige, schwerbrennbare Modifikationen.
24. Vernetzbare Acrylharze, die sich von substituierten Acrylsäureestern ableiten, wie z.B. von Epoxyacrylaten, Urethan-acrylaten oder Polyester-acrylaten.
25. Alkydharze, Polyesterharze und Acrylatharze, die mit Melaminharzen, Harnstoffharzen, Isocyanaten, Isocyanuraten, Polyisocyanaten oder Epoxidharzen vernetzt sind.
26. Vernetzte Epoxidharze, die sich von aliphatischen, cycloaliphatischen, heterocyclischen oder aromatischen Glycidylverbindungen ableiten, z.B. Produkte von Bisphenol-A-diglycidylethem, Bisphenol-F-diglycidylethern, die mittels üblichen Härtern wie z.B. Anhydriden oder Aminen mit oder ohne Beschleunigern vemetzt werden.
27. Natürliche Polymere, wie Cellulose, Naturkautschuk, Gelatine, sowie deren polymerhomolog chemisch abgewandelte Derivate, wie Celluloseacetate, -propionate und -butyrate, bzw. die Celluloseether, wie Methylcellulose; sowie Kolophoniumharze und Derivate.
28. Mischungen (Polyblends) der vorgenannten Polymeren, wie z.B. PP/EPDM, Polyamid/-EPDM oder ABS, PVC/EVA, PVC/ABS, PVC/MBS, PC/ABS, PBTP/ABS, PC/ASA, PC/PBT, PVC/CPE, PVC/Acrylate, POM/thermoplastisches PUR, PC/thermoplastisches PUR, POM/-Acrylat, POM/MBS, PPO/HIPS, PPO/PA 6.6 und Copolymere, PA/HDPE, PA/PP, PA/PPO, PBT/PC/ABS oder PBT/PET/PC.

Im Rahmen der vorliegenden Erfindung soll auch Papier als strukturvernetztes Polymer verstanden werden insbesondere in Kartonform, welcher noch zusätzlich mit beispielsweise Teflon® beschichtet sein kann. Derartige Substrate sind beispielsweise im Handel erhältlich.

Bevorzugt handelt es sich bei dem thermoplastischen, vemetzten oder strukturvemetzten Kunststoff um ein Polyolefin, Polyamid, Polyacrylat, Polycarbonat, Polystyrol oder um einen Acryl/Melamin-, Alkyd- oder Polyurethanlack.

Besonders bevorzugt ist Polycarbonat, Polyethylen, Polypropylen, Polyamid und Polyimid.

Die Kunststoffe können in Form von Folien, Spritzgussteilen, Extrusionswerkstücken, Fasern, Filzen oder Geweben vorliegen.

Als anorganische Substrate kommen vor allem Gläser, Metalloxide und Metalle in Betracht. Es kann sich dabei um Silikate und Halbmetall- oder Metalloxid Gläser handeln, die bevorzugt als Pulver mit mittleren Teilchendurchmessern von 10 nm bis 2000 µm vorliegen. Es kann sich sowohl um kompakte als auch poröse Teilchen handeln. Beispiele für Oxide und Silikate sind SiO₂, TiO₂, ZrO₂, MgO, NiO, WO₃, Al₂O₃, La₂O₃, Silikagele, Tone und Zeolithe. Bevorzugte anorganische Substrate neben den Metallen sind Silicagele, Aluminiumoxid, Titanoxid oder Glas und deren Gemische.

Zur Verwendung im erfindungsgemässen Verfahren sind grundsätzlich alle Photoinitatoren, welche mindestens eine ethylenisch ungesättigte Gruppe aufweisen, geeignet.

Als metallische Substrate kommen insbesondere Fe, Al, Ti, Ni, Mo, Cr oder Stahllegierungen in Betracht.

Bevorzugt ist der Photoinitiator eine Verbindung der Formel I oder la

(RG)-A-(IN) (I),

(IN)-A-(RG')-A-(IN) (Ia),

worin
(IN) eine Photoinitiatorgrundstruktur ist,
A für eine Spacergruppe oder eine Einfachbindung steht,
(RG) mindestens eine funktionelle ethylenisch ungesättigte Gruppe bedeutet, und
(RG') für einen zweiwertigen Rest, der mindestens eine funktionelle ethylenisch ungesättigte Gruppe enthält, steht.

Bevorzugt sind Verbindungen der Formel I oder la, worin
(IN) eine Photoinitiatorgrundstruktur der Formel (II) oder (III) ist 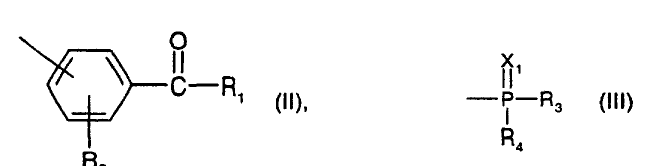
R₁ eine Gruppe (A), (B) oder (III) darstellt

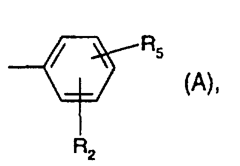

   -CR₆R₇R₈ (B);
R₂ für Wasserstoff, C ₁-C₁₂-Alkyl, Halogen, die Gruppe (RG)-A- oder, falls R₁ für eine Gruppe (A) steht, zwei zur Carbonylgruppe orthoständige Reste R₂ zusammen auch für -Soder 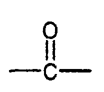 stehen können;
R₃ und R₄ unabhängig voneinander C₁-C₆-Alkyl, C₁-C₆-Alkanoyl, Phenyl oder Benzoyl sind, wobei die Reste Phenyl oder Benzoyl, jeweils gegebenenfalls mit Halogen, C₁-C₆-Alkyl, C₁-C₆-Alkylthio oder C₁-C₆-Alkoxy substituiert sind;
R₅ Wasserstoff, Halogen, C ₁-C₁₂-Alkyl oder C₁-C₁₂-Alkoxy oder die Gruppe (RG)-A-bedeutet;
R₆ OR₉ oder N(R₉)₂ ist oder für 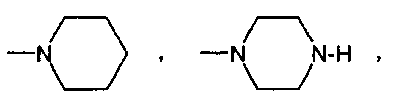 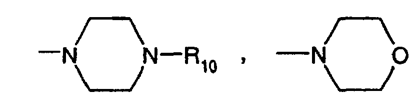 oder SO₂R₉ steht;
R₇ und R₈ jeweils unabhängig voneinander H, C₁-C₁₂-Alkyl, C₂-C₁₂-Alkenyl, C₁-C₁₂-Alkoxy, Phenyl, Benzyl oder zusammen C₂-C₆-Alkylen sind;
R₉ Wasserstoff, C₁-C₆-Alkyl oder C₁-C₆-Alkanoyl ist;
R₁₀ Wasserstoff, C₁-C₁₂-Alkyl oder Phenyl ist; und
X₁ Sauerstoff oder Schwefel bedeutet.

Bevorzugt bedeutet in den Verbindungen der Formel I oder la (IN) eine Gruppe 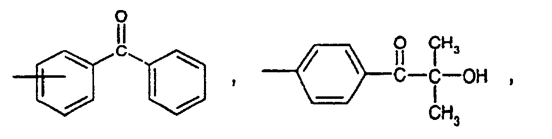 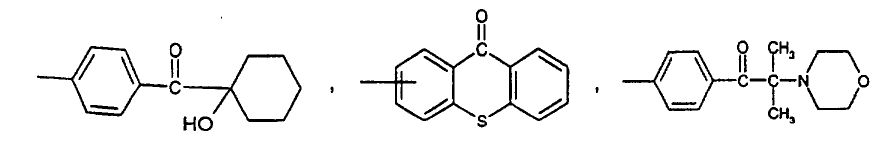 oder 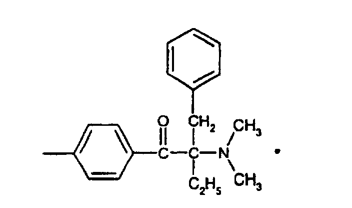 Bevorzugt sind Verbindungen der Formel I oder Ia, worin
A für eine Spacergruppe -Z-[(A₁)ₐ-Y]_{c}-[(A₂)_{b}-X]_{d} steht;
X, Y und Z jeweils unabhängig voneinander für eine Einfachbindung, -O-, -S- ,-N(R₁₀)-, - (CO)-, -(CO)O-, -(CO)N(R₁₀)-, -O-(CO)-, -N(R₁₀)-(CO)- oder -N(R₁₀)-(CO)O- stehen;
A₁ und A₂ unabhängig voneinander C₁-C₄-Alkylen, C₃-C₁₂-Cycloalkylen, Phenylen, Phenylen-C₁-C₄-Alkylen oder C₁-C₄-Alkylen-Phenylen-C₁-C₄-Alkylen bedeuten;
a, b, c und d unabhängig voneinander für die Zahlen 0 bis 4 stehen; und
R₁₀ wie vorstehend definiert ist.

Besonders bevorzugt sind Verbindungen der Formel I oder la, worin A eine Spacergruppe -Z-[(CH₂)ₐ-Y]_{c}-[(CH₂)_{b}-X]_{d}- ist und X, Y, Z, a,b,c und d die vorstehend angegebenen Bedeutungen haben.

Besonders bevorzugt in den Verbindungen der Formel I oder Ia stehen
(RG) für R_{c}R_{b}C=CRₐ-,
(RG') für 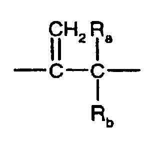 und
Rₐ, R_{b}, R_{c} jeweils für H oder C₁-C₆-Alkyl, insbesondere H oder CH₃.

Die Herstellung solcher Photoinitiatorverbindungen ist dem Fachmann geläufig und bereits in einer Vielzahl von Publikationen beschrieben.

So lassen sich z.B. ungesättigte Gruppen enthaltende Verbindungen durch Umsetzung von 4-[2-Hydroxyethoxy)-benzoyl]-1-hydroxy-1-methyl-ethan (Irgacure® 2959, Ciba Spezialitätenchemie) mit Isocyanaten enthaltend Acryloyl- oder Methacryloylgruppen oder anderen Acryloyl- oder Methacryloylgruppen enthaltenden Verbindungen herstellen, vgl. z. B. US 4922004.

Den nachstehend angegebenen Publikationen sind konkrete Beispiele für geeignete Photoinitiatorverbindungen mit ethylenisch ungesättigter Funktion, sowie deren Herstellung zu entnehmen:
Ungesättigte Aceto- und Benzophenonderivate sind beispielsweise in US 3214492, US 3429852, US 3622848 und US 4304895 beschrieben, z.B. 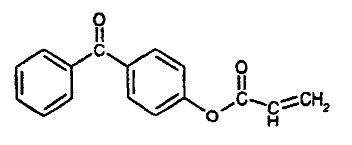 Copolymerisierbare, ethylenisch ungesättigte Acetophenonverbindungen, sind beispielsweise US 4922004 zu entnehmen, z.B 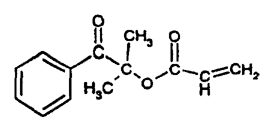 oder 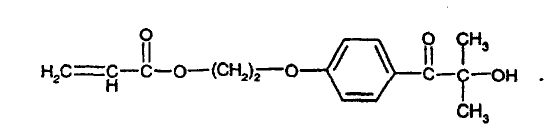 2-Acryloyl-thioxanthon ist in Eur. Polym. J. 23, 985 (1987) publiziert.

Beispiele wie 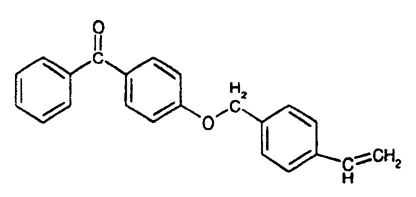 sind in der DE 2818763 dargestellt.
Weitere ungesättigte carbonatgruppenhaltige Photoinitiator-Verbindungen sind der EP 377191 zu entnehmen.
Uvecryl® P36, der Firma UCB, ist ein durch Ethylenoxideinheiten mit einer Acrylfunktion verbundenes Benzophenon (vgl. Technical Bulletin 2480/885 (1985) der Firma UCB oder New.
Polym. Mat. 1, 63 (1987)): 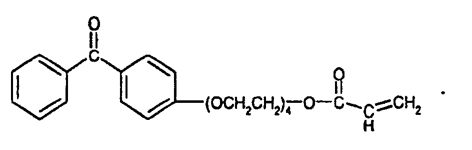 In Chem. Abstr. 128: 283649r ist 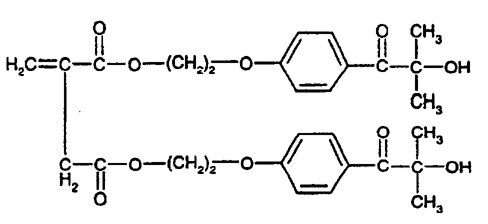 publiziert.

Der DE 19501025 sind weitere ethylenisch ungesättigte geeignete Photoinitiatorverbindungen zu entnehmen. Beispiele sind 4-Vinyloxycarbonyloxybenzophenon, 4-Vinyloxycarbonyloxy-4'-chlorbenzophenon, 4-Vinyloxycarbonyloxy-4'-methoxybenzophenon, N-Vinyloxycarbonyl-4-aminobenzophenon, Vinyloxycarbonyloxy-4'-fluorbenzophenon, 2-Vinyloxycarbonyloxy-4'-methoxybenzophenon, 2-Vinyloxycarbonyloxy-5-fluor-4'-chlorbenzophenon, 4-Vinyloxycarbonyloxyacetophenon, 2-Vinyloxycarbonyloxyacetophenon, N-Vinyloxycarbonyl-4-aminoacetophenon, 4-Vinyloxycarbonyloxybenzil, 4-Vinyloxycarbonyloxy-4'-methoxybenzil, Vinyloxycarbonylbenzoinether, 4-Methoxybenzoinvinyloxycarbonylether, Phenyl(2-vinyloxycarbonyloxy-2-propyl)-keton, (4-Isopropylphenyl)-(2-vinyloxycarbonyloxy-2-propyl)-keton, Phenyl-(1-vinyloxycarbonyloxy)-cyclohexylketon, 2-Vinyloxycarbonyloxy-9-fluorenon, 2-(N-Vinyloxycarbonyl)-9-aminofluorenon, 2-Vinylcarbonyloxymethylanthrachinon, 2-(N-Vinyloxycarbonyl)-aminoanthrachinon, 2-Vinyloxycarbonyloxythioxanthon, 3-Vinylcarbonyloxythioxanthon oder

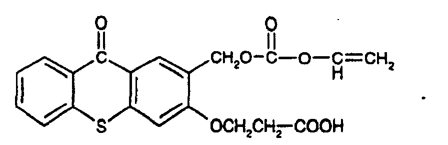

In US 4672079 ist unter anderem die Herstellung von 2-Hydroxy-2-methyl(4-vinylpropiophenon), 2-Hydroxy-2-methyl-p-(1-methylvinyl)propiophenon, p-Vinylbenzoylcyclohexanol, p-(1-Methylvinyl)benzoyl-cyclohexanol offenbart.
Geeignet sind auch die in JP Kokai Hei 2-292307 beschriebenen Umsetzungsprodukte aus 4[2-Hydroxyethoxy)-benzoyl]-1-hydroxy-1-methyl-ethan (Irgacure® 2959, Ciba Spezialitätenchemie) und Isocyanaten enthaltend Acryloyl oder Methacryloylgruppen, beispielsweise 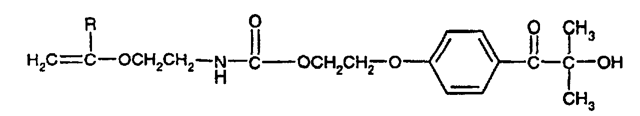 oder 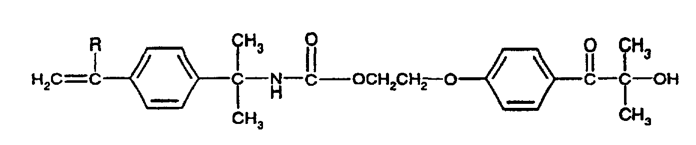 (mit R= H oder CH₃).

Weitere Beispiele für geeignete Photoinitiatoren sind 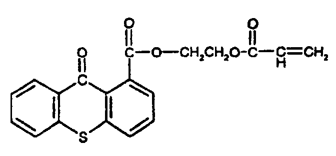 oder

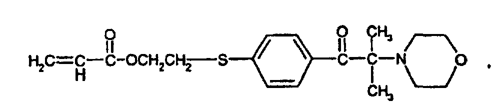

Die folgenden Beispiele sind in Radcure '86, Conference Proceedings, 4-43 bis 4-54 von W. Bäumer et al. beschrieben 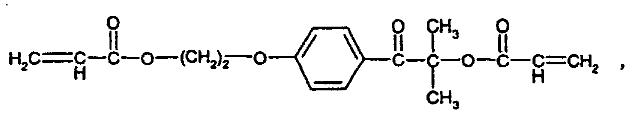 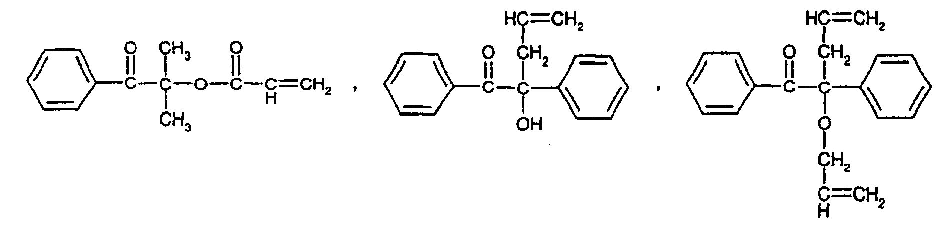 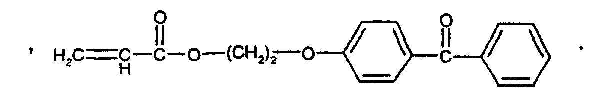 G. Wehner et al. berichten in Radtech '90 North America über

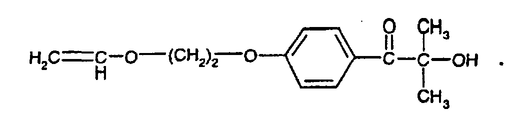

Die Bedeutung der Substituenten in den verschiedenen Resten ist nachstehend erläutert.

C₁-C₁₂-Alkyl ist linear oder verzweigt und ist beispielsweise, C₁-C₈-, C₁-C₆- oder C₁-C₄-Alkyl.

Beispiele sind Methyl, Ethyl, Propyl, Isopropyl, n-Butyl, sec-Butyl, iso-Butyl, tert-Butyl, Pentyl, Hexyl, Heptyl, 2,4,4-Trimethyl-pentyl, 2-Ethylhexyl, Octyl, Nonyl, Decyl, Undecyl oder Dodecyl insbesondere z.B. Methyl oder Butyl.

C₁-C₆-Alkyl und C₁-C₄-Alkyl sind ebenfalls linear oder verzweigt und haben z.B. die oben angegebenen Bedeutungen bis zur entsprechenden Anzahl der C-Atome. C₁-C₆-Alkyl-Substituenten für Benzoyl oder Phenyl sind, insbesondere C₁-C₄-Alkyl, z.B. Methyl oder Butyl.

Halogen bedeutet Fluor, Chlor, Brom und lod, insbesondere Chlor und Brom, vorzugsweise Chlor.

Falls R₁ für eine Gruppe (A) steht, und zwei zur Carbonylgruppe orthoständige Reste R₂ zusammen auch für -S- oder 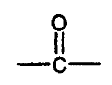 stehen, so ergeben sich beispielsweise Strukturen mit Thioxanthongrundkörper oder Anthrachinongrundkörper 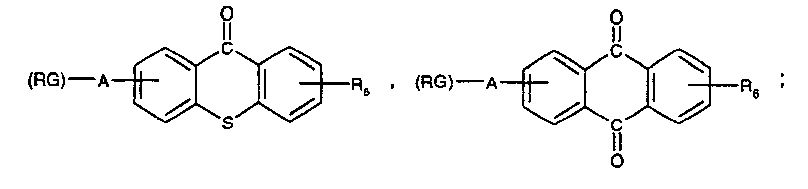 C₁-C₆-Alkanoyl ist linear oder verzweigt und ist, zum Beispiel C₁-C₄-Alkanoyl. Beispiele sind Formyl, Acetyl, Propionyl, Butanoyl, Isobutanoyl, Pentanoyl oder Hexanoyl, vorzugsweise Acetyl.
C₁-C₄-Alkanoyl hat die vorstehend angegebenen Bedeutungen bis zur entsprechenden Anzahl der C-Atome.

C₁-C₁₂-Alkoxy steht für lineare oder verzweigte Reste und ist beispielsweise C₁-C₈-, C₁-C₆oder C₁-C₄-Alkoxy. Beispiele sind Methoxy, Ethoxy, Propoxy, Isopropoxy, n-Butyloxy, sec-Butyloxy, iso-Butyloxy, tert-Butyloxy, Pentyloxy, Hexyloxy, Heptyloxy, 2,4,4-Trimethylpentyloxy, 2-Ethylhexyloxy, Octyloxy, Nonyloxy, Decyloxy oder Dodecyloxy, insbesondere Methoxy, Ethoxy, Propoxy, Isopropoxy, n-Butyl-oxy, sec-Butyloxy, iso-Butyloxy, tert-Butyloxy, vorzugsweise Methoxy.

C₁-C₈-Alkoxy, C₁-C₆-Alkoxy und C₁-C₄-Alkoxy sind ebenfalls linear oder verzweigt und haben z.B. die oben angegebenen Bedeutungen bis zur entsprechenden Anzahl der C-Atome.

C₁-C₆-Alkylthio steht für lineare oder verzweigte Reste und ist beispielsweise C₁-C₄-Alkylthio. Beispiele sind Methylthio, Ethylthio, Propylthio, Isopropylthio, n-Butylthio, sec-Butylthio, iso-Butylthio, tert-Butytthio, Pentylthio oder Hexylthio, insbesondere Methylthio, Ethylthio, Propylthio, Isopropylthio, n-Butylthio, sec-Butylthio, iso-Butylthio, tert-Butylthio, vorzugsweise Methylthio.

C₁-C₄-Alkylthio ist ebenfalls linear oder verzweigt und hat z.B. die oben angegebenen Bedeutungen bis zur entsprechenden Anzahl der C-Atome.

Mit Halogen, C₁-C₆-Alkyl, C₁-C₆Alkylthio oder C₁-C₆-Alkoxy substituierte Reste Phenyl oder Benzoyl sind z.B. ein- bis fünffach, z.B. ein-, zwei- oder dreifach, insbesondere zwei- oder dreifach am Phenylring substituiert. Bevorzugt sind z.B. 2,4,6-Trimethylbenzoyl, 2,6-Dichlorbenzoyl, 2,6-Dimethylbenzoyl oder 2,6-Dimethoxybenzoyl.

C₁-C₄-Alkylen und C₂-C₆-Alkylen sind lineares oder verzweigtes Alkylen, beispielsweise C₂-C₄-Alkylen, wie z.B. Methylen, Ethylen, Propylen, Isopropylen, n-Butylen, sec-Butylen, isoButylen, tert-Butylen, Pentylen oder Hexylen. Bevorzugt ist C₁-C₄-Alkylen, z.B. Ethylen oder Butylen, 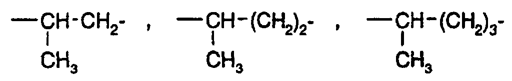 oder -C(CH₃)₂-CH₂-, sowie Methylen und Ethylen .

Phenylen-C₁-C₄-Alkylen steht für Phenylen, welches in einer Position des aromatischen Ringes mit C₁-C₄-Alkylen substituiert ist, während C₁-C₄-Alkylen-Phenylen-C₁-C₄-Alkylen für Phenylen steht, welches in zwei Positionen des Phenylenringes mit C₁-C₄-Alkylen substituiert ist. Die Alkylenreste sind dabei jeweils linear oder verzweigt und haben z.B. die vorstehend angegeben Bedeutungen bis zur entsprechenden Anzahl der C-Atome. Beispiele sind

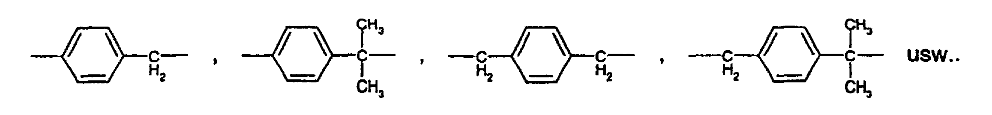

Die Alkylengruppen können jedoch ebenso an anderen Stellen des Phenylenringes positioniert sein, z.B. auch in 1,3-Stellung.

Cycloalkylen ist z.B. C₃-C₁₂-, C₃-C₈-Cycloalkylen, beispielsweise, Cyclopropylen, Cyclopentylen, Cyclohexylen, Cyclooctylen, Cyclododecylen, insbesondere Cyclopentylen und Cyclohexylen, vorzugsweise Cyclohexylen. C₃-C₁₂-Cycloalkylen steht jedoch ebenfalls für strukturelle Einheiten wie 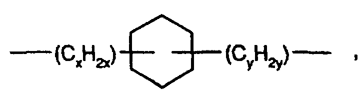 worin x und y unabhängig voneinander 0-6 bedeuten und die Summe von x + y ≤ 6 ist, oder 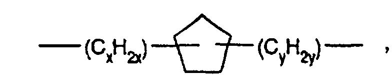 worin x und y unabhängig voneinander 0-7 sind und die Summe von x+y ≤ 7 ist.

Phenylen bedeutet 1,4-, 1,2- oder 1,3-Phenylen, insbesondere 1,4-Phenylen.

C₂-C₁₂-Alkenyl-Reste können ein- oder mehrfach ungesättigt, sowie linear oder verzweigt sein und sind beispielsweise C₂-C₈-, C₂-C₆- oder C₂-C₄-Alkenyl. Beispiele sind Allyl, Methallyl, 1,1-Dimethylallyl, 1-Butenyl, 2-Butenyl, 1,3-Pentadienyl, 1-Hexenyl, 1-Octenyl, Decenyl oder Dodecenyl, insbesondere Allyl.

Bilden R₇ und R₈ zusammen C₂-C₆-Alkylen, so stellen sie gemeinsam mit dem C-Atom, an welches sie gebunden sind einen C₃-C₇-Cycloalkylring dar. C₃-C₇Cycloalkyl ist zum Beispiel Cyclopropyl, Cyclopentyl, Cyclohexyl, Cycloheptyl, insbesondere Cyclopentyl und Cyclohexyl, vorzugsweise Cyclohexyl.

R_{c}R_{b}C=CRₐ- bedeutet z.B. -CH=CH₂ oder -C(CH₃)=CH₂, bevorzugt -CH=CH₂.

Die Photoinitiatoren können nach Abschalten der radikalbildenden Entladung oder Belichtung (Prozessschritt a)) zum Beispiel auf einer heizbaren Vorrichtung im Vakuum verdampft werden, so dass sie sich auf dem behandelten Werkstück niederschlagen und dort mit Radikalstellen reagieren. Die Verdampfung kann als Feststoff, Schmelze oder mit einem geeigneten Lösungsmittel erfolgen, wobei der Dampfdruck des Lösungsmittels bevorzugt nahe bei dem des Photoinitiators liegt.

Im Falle einer Corona Entladung unter atmosphärischen Bedingungen kann der Photinitiator auch durch Aufsprühen aus einer Lösung aufgebracht werden. Vorzugsweise geschieht dies möglichst unmittelbar anschliessend an die Corona Entladung, beispielsweise bei einem kontinuierlichen Verfahren durch Düsen hinter der Entladungszone.

Im Anschluss an das Aufbringen des Photoinitators kann das Werkstück gelagert werden oder direkt weiter verarbeitet werden, wobei eine strahlungshärtbare Lackschicht, enthaltend ethylenisch ungesättigte Bindungen, mittels bekannter Technologie aufgebracht wird. Dies kann mittels Giessen, Tauchen, Sprühen, Streichen, Rakeln, Walzen oder Schleudern geschehen.

Die ungesättigten Verbindungen der strahlungshärtbaren Lackzusammensetzung können eine oder mehrere ethylenisch ungesättigte Doppelbindungen enthalten. Sie können niedermolekular (monomer) oder höhermolekular (oligomer) sein. Beispiele für Monomere mit einer Doppelbindung sind Alkyl- oder Hydroxyalkyl-acrylate oder -methacrylate, wie z.B. Methyl-, Ethyl-, Butyl-, 2-Ethylhexyl- oder 2-Hydroxyethylacrylat, Isobornylacrylat, Methyl- oder Ethylmethacrylat. Interessant sind auch Silicon-acrylate. Weitere Beispiele sind Acrylnitril, Acrylamid, Methacrylamid, N-substituierte (Meth)acryl-amide, Vinylester wie Vinylacetat, Vinylether wie Isobutylvinylether, Styrol, Alkyl- und Halogenstyrole, N-Vinylpyrrolidon, Vinylchlorid oder Vinylidenchlorid.

Beispiele für Monomere mit mehreren Doppelbindungen sind Ethylenglykol-, Propylenglykol-, Neopentylglykol-, Hexamethylenglykol- oder Bisphenol-A-diacrylat, 4,4'-Bis(2-acryloyloxyethoxy)-diphenylpropan, Trimethylolpropan-triacrylat, Pentaerythrittriacrylat oder -tetraacrylat, Vinylacrylat, Divinylbenzol, Divinylsuccinat, Diallylphthalat, Triallylphosphat, Triallylisocyanurat, Tris(hydroxyethyl) isocyanurat-triacrylat oder Tris-(2-acryloylethyl)isocyanurat.

Beispiele für höhermolekulare (oligomere) mehrfach ungesättigte Verbindungen sind acrylierte Epoxidharze, acrylierte oder Vinylether- oder Epoxy-Gruppen enthaltende Polyester, Polyurethane und Polyether. Weitere Beispiele für ungesättigte Oligomere sind ungesättigte Polyesterharze, die meist aus Maleinsäure, Phthalsäure und einem oder mehreren Diolen hergestellt werden und Molekulargewichte von etwa 500 bis 3000 besitzen. Daneben können auch Vinylether-Monomere und -Oligomere, sowie maleat-terminierte Oligomere mit Polyester-, Polyurethan-, Polyether-, Polyvinylether- und Epoxidhauptketten eingesetzt werden. Insbesondere Kombinationen von Vinylethergruppen tragenden Oligomeren und Polymeren, wie sie in der WO 90/01512 beschrieben sind, sind gut geeignet. Aber auch Copolymere aus Vinylether und Maleinsäure funktionalisierten Monomeren kommen in Frage. Solche ungesättigten Oligomere kann man auch als Prepolymere bezeichnen.

Besonders geeignet sind z.B. Ester von ethylenisch ungesättigten Carbonsäuren und Polyolen oder Polyepoxiden, und Polymere mit ethylenisch ungesättigten Gruppen in der Kette oder in Seitengruppen, wie z. B. ungesättigte Polyester, Polyamide und Polyurethane und Copolymere hiervon, Alkydharze, Polybutadien und Butadien-Copolymere, Polyisopren und Iso-pren-Copolymere, Polymere und Copolymere mit (Meth)Acrylgruppen in Seitenketten, sowie Mischungen von einem oder mehreren solcher Polymerer.

Beispiele für ungesättigte Carbonsäuren sind Acrylsäure, Methacrylsäure, Crotonsäure, Itaconsäure, Zimtsäure, ungesättigte Fettsäuren wie Linolensäure oder Oelsäure. Bevorzugt sind Acryl- und Methacrylsäure.
Als Polyole sind aromatische und besonders aliphatische und cycloaliphatische Polyole geeignet. Beispiele für aromatische Polyole sind Hydrochinon, 4,4'-Dihydroxydiphenyl, 2,2-Di(4-hydroxyphenyl)-propan, sowie Novolake und Resole. Beispiele für Polyepoxide sind solche auf der Basis der genannten Polyole, besonders der aromatischen Polyole und Epichlorhydrin. Ferner sind auch Polymere und Copolymere, die Hydroxylgruppen in der Polymerkette oder in Seitengruppen enthalten, wie z.B. Polyvinylalkohol und Copolymere davon oder Polymethacrylsäurehydroxyalkylester oder Copolymere davon, als Polyole geeignet. Weitere geeignete Polyole sind Oligoester mit Hydroxylendgruppen.

Beispiele für aliphatische und cycloaliphatische Polyole sind Alkylendiole mit bevorzugt 2 bis 12 C-Atomen, wie Ethylenglykol, 1,2- oder 1,3-Propandiol, 1,2-, 1,3- oder 1,4-Butandiol, Pentandiol, Hexandiol,Octandiol, Dodecandiol, Diethylenglykol, Triethylenglykol, Polyethylenglykole mit Molekulargewichten von bevorzugt 200 bis 1500, 1,3-Cyclopentandiol, 1,2-, 1,3- oder 1,4-Cyclohexandiol, 1,4-Dihydroxymethylcyclohexan, Glycerin, Tris-(β-hydroxyethyl)amin, Trimethylolethan, Trimethylolpropan, Pentaerythrit, Dipentaerythrit und Sorbit.

Die Polyole können teilweise oder vollständig mit einer oder verschiedenen ungesättigten Carbonsäuren verestert sein, wobei in Teilestern die freien Hydroxylgruppen modifiziert, z.B. verethert oder mit anderen Carbonsäuren verestert sein können.

### Beispiele für Ester sind:

Trimethylolpropantriacrylat, Trimethylolethantriacrylat, Trimethylolpropantrimethacrylat, Trimethylolethantrimethacrylat, Tetramethylenglykoldimethacrylat, Triethylenglykoldimethacrylat, Tetraethylenglykoldiacrylat, Pentaerythritdiacrylat, Pentaerythrittriacrylat, Pentaerythrittetraacrylat, Dipentaerythritdiacrylat, Dipentaerythrittriacrylat, Dipentaerythrit-tetraacrylat, Dipentaerythritpentaacrylat, Dipentaerythrithexaacrylat, Tripentaerythritocta-acrylat, Pentaerythritdimethacrylat, Pentaerythrittrimethacrylat, Dipentaerythritdimethacrylat, Dipentaerythrittetramethacrylat, Tripentaerythritoctamethacrylat, Pentaerythritdiitaconat, Dipentaerythrittrisitaconat, Dipentaerythritpentaitaconat, Dipentaerythrithexaitaconat, Ethylenglykoldiacrylat, 1,3-Butandioldiacrylat, 1,3-Butandioldimethacrylat, 1,4-Butandioldi-itaconat, Sorbittriacrylat, Sorbittetraacrylat, Pentaerythrit-modifiziert-triacrylat, Sorbittetra-methacrylat, Sorbitpentaacrylat, Sorbithexaacrylat, Oligoesteracrylate und -methacrylate, Glycerindi- und -triacrylat, 1,4-Cyclohexandiacrylat, Bisacrylate und Bismethacrylate von Polyethylenglykol mit Molekulargewicht von 200 bis 1500, oder Gemische davon.
Als Komponente sind auch die Amide gleicher oder verschiedener ungesättigter Carbonsäuren von aromatischen, cycloaliphatischen und aliphatischen Polyaminen mit bevorzugt 2 bis 6, besonders 2 bis 4 Aminogruppen geeignet. Beispiele für solche Polyamine sind Ethylendiamin, 1,2- oder 1,3-Propylendiamin, 1,2-, 1,3- oder 1,4-Butylendiamin, 1,5-Pentylendiamin, 1,6-Hexylendiamin, Octylendiamin, Dodecylendiamin, 1,4-Diaminocyclohexan, Isophorondiamin, Phenylendiamin, Bisphenylendiamin, Di-β-aminoethylether, Diethylentriamin, Triethylentetramin, Di(β-aminoethoxy)- oder Di(β-aminopropoxy)ethan. Weitere geeignete Polyamine sind Polymere und Copolymere mit gegebenenfalls zusätzlichen Aminogruppen in der Seitenkette und Oligoamide mit Aminoendgruppen. Beispiele für solche ungesättigten Amide sind: Methylen-bis-acrylamid, 1,6-Hexamethylen-bis-acryl-amid, Diethylentriamin-tris-methacrylamid, Bis(methacrylamidopropoxy)-ethan, β-Methacrylamidoethylmethacrylat, N[(β-Hydroxyethoxy)ethyl]-acrylamid.

Geeignete ungesättigte Polyester und Polyamide leiten sich z.B. von Maleinsäure und Diolen oder Diaminen ab. Die Maleinsäure kann teilweise durch andere Dicarbonsäuren ersetzt sein. Sie können zusammen mit ethylenisch ungesättigten Comonomeren, z.B. Styrol, eingesetzt werden. Die Polyester und Polyamide können sich auch von Dicarbon-säuren und ethylenisch ungesättigten Diolen oder Diaminen ableiten, besonders von längerkettigen mit z.B. 6 bis 20 C-Atomen. Beispiele für Polyurethane sind solche, die aus gesättigten oder ungesättigten Diisocyanaten und ungesättigten bzw. gesättigten Diolen aufgebaut sind.

Polybutadien und Polyisopren und Copolymere davon sind bekannt. Geeignete Comonomere sind z.B. Olefine wie Ethylen, Propen, Buten, Hexen, (Meth)-Acrytate, Acryl-nitril, Styrol oder Vinylchlorid. Polymere mit (Meth)-Acrylatgruppen in der Seitenkette sind ebenfalls bekannt. Es kann sich z.B. um Umsetzungsprodukte von Epoxidharzen auf Novolak-basis mit (Meth)-Acrylsäure handeln, um Homo- oder Copolymere des Vinylalkohols oder deren Hydroxyalkylderivaten, die mit (Meth)-Acrytsäure verestert sind, oder um Homo- und Copolymere von (Meth)-Acrylaten, die mit Hydroxyalkyl(meth)acrylaten verestert sind.

Besonders bevorzugt wird als einfach oder mehrfach ethylenisch ungesättigte Verbindung eine Acrylat- oder Methacrylatverbindung verwendet.

Ganz besonders bevorzugt sind mehrfach ungesättigte Acrylatverbindungen, wie sie vorstehend bereits aufgeführt wurden.
Besonders bevorzugt ist ein Verfahren, bei welchem mindestens eines der ethylenisch ungesättigten Monomeren oder Oligomeren der strahlungshärtbaren Zusammensetzung ein mono-, di-, tri- oder tetra-funktionelles Acrylat oder Methacrylat ist.

Bevorzugt enthält die Zusammensetzung neben mindestens einem ethylenisch ungesättigtes Monomer oder Oligomer, mindestens einen weiteren Photoinitiator oder Coinitiator für die Härtung mit UVNIS Strahlung.

Unter UV/VIS Strahlung soll im Rahmen der vorliegenden Erfindung elektromagnetische Strahlung im Wellenlängenbereich von 250 nm bis 450 nm verstanden werden. Bevorzugt ist der Bereich von 305 nm bis 450 nm. Geeignete Lampen sind dem Fachmann bekannt und im Handel erhältlich.

Als Photoinitiator in den strahlungshärtbaren Lacken können sowohl die Verbindungen der Formel I oder Ia verwendet werden als auch alle übrigen aus dem Stand der Technik bekannten Initiatoren.

Typische Beispiele sind nachstehend erwähnt, die sowohl einzeln als auch in Gemischen miteinander verwendet werden können. Zum Beispiel Benzophenone, Benzophenonderivate, Acetophenon, Acetophenonderivate, wie beispielsweise α-Hydroxycycloalkylphenylketone oder 2-Hydroxy-2-methyl-1-phenyl-propanon, Dialkoxyacetophenone, α-Hydroxy- oder α-Aminoacetophenone, wie z.B. (4-Methylthiobenzoyl)-1-methyl-1-morpholino-ethan, (4-Morpholino-benzoyl)-1-benzyl-1-dimethylamino-propan, 4-Aroyl-1,3-Dioxolane, Benzoinalkylethe und Benzilketale, wie z.B. Benzildimethylketal, Phenylglyoxalate und Derivate davon, dimere Phenylglyoxalate, Monoacylphosphinoxide, wie z.B. (2,4,6-Trimethylbenzoyl)-phenylphosphinoxid, Bisacylphosphinoxide, wie z.B. Bis(2,6-dimethoxybenzoyl)-(2,4,4-trimethyl-pent-1-yl)phosphinoxid, Bis(2,4,6-trimethylbenzoyl)-phenyl-phosphinoxid oder Bis(2,4,6-trimethylbenzoyl)-(2,4-dipentoxyphenyl)phosphinoxid, Trisacylphosphinoxide, Ferroceniumverbir dungen oder Titanocene, wie beispielsweise Dicyclopentadienyl-bis(2,6-difluoro-3-pyrrolophenyl)-titan. Eine weitere Klasse geeigneter Photoinitiatoren ist die der Oximester. Beispielhaft sind folgende Verbindungen genannt: 1-(4-Phenylsulfanyl-phenyl)-butan-1,2-dion-2-oxim-O-benzoat, 1-(4-Phenylsulfanyl-phenyl)-octan-1,2-dion-2-oxim-O-benzoat, 1-(4-Phenylsulfanylphenyl)-octan-1-on-oxim-O-acetat ,1-(4-Phenylsulfanyl-phenyl)-butan-1-on-oxim-O-acetat or 1-(4-Phenylsulfanyl-phenyl)-octan-1,2-dion-2-oxim-O-benzoat.

Als Coinitiatoren kommen zum Beispiel Sensibilisatoren in Frage, welche die spektrale Empfindlichkeit verschieben bzw. verbreitern und dadurch eine Beschleunigung der Photopolymerisation bewirken. Dies sind insbesondere aromatische Carbonylverbindungen wie z.B. Benzophenon-, Thioxanthon-, insbesondere auch Isopropylthioxanthon, Anthrachinon- und 3-Acylcumarinderivate, Terphenyle, Styrylketone, sowie 3-(Aroylmethylen)-thiazoline, Campherchinon, aber auch Eosin-, Rhodamin- und Erythrosin-Farbstoffe.
Als Photosensibilisatoren können beispielsweise auch Amine betrachtet werden, wenn die erfindungsgemäss aufgepfropfte Photoinitiatorschicht aus einem Benzophenon oder Benzophenonderivat besteht.

Weitere Beispiele für Photosensibilisatoren sind

### 1. Thioxanthone

Thioxanthon, 2-Isopropylthioxanthon, 2-Chlorothioxanthon, 2-Dodecylthioxanthon, 2,4-Diethylthioxanthon, 2,4-Dimethylthioxanthon, 1-Methoxycarbonylthioxanthon, 2-Ethoxycarbonylthioxanthon, 3-(2-Methoxyethoxycarbonyl)-thioxanthon, 4-Butoxycarbonylthioxanthon, 3-Butoxycarbonyl-7-methylthioxanthon, 1-Cyano-3-chlorothioxanthon, 1-Ethoxycarbonyl-3-chlorothioxanthon, 1-Ethoxycarbonyl-3-ethoxythioxanthon, 1-Ethoxycarbonyl-3-aminothioxanthon, 1-Ethoxycarbonyl-3-phenylsulfurylthioxanthon, 3,4-Di-[2-(2-methoxyethoxy)ethoxycarbonyl]-thioxanthon, 1-Ethoxycarbonyl-3-(1-methyl-1-morpholinoethyl)-thioxanthon, 2-Methyl-6-dimethoxymethyl-thioxanthon, 2-Methyl-6-(1,1-dimethoxybenzyl)-thioxanthon, 2-Morpholinomethylthioxanthon, 2-Methyl-6-morpholinomethylthioxanthon, N-Allylthioxanthone-3,4-dicarboximid, N-Octylthioxanthon-3,4-dicarboximid, N-(1,1,3,3-Tetramethylbutyl)-thioxanthon-3,4-dicarboximid, 1-Phenoxythioxanthon, 6-Ethoxycarbonyl-2-methoxythioxanthon, 6-Ethoxycarbonyl-2-methylthioxanthon, Thioxanthon-2-polyethylenglycolester, 2-Hydroxy-3-(3,4-dimethyl-9-oxo-9H-thioxanthon-2-yloxy)-N,N,N-trimethyl-1-propanaminiumchlorid;

### 2. Benzophenone

Benzophenon, 4-Phenylbenzophenon, 4-Methoxybenzophenon, 4,4'-Dimethoxybenzophenon, 4,4'-Dimethylbenzophenon, 4,4'-Dichlorobenzophenon 4,4'-Dimethylaminobenzophenon, 4,4'-Diethylaminobenzophenon, 4-Methylbenzophenon, 2,4,6-Trimethylbenzophenon, 4-(4-Methylthiophenyl)-benzophenon, 3,3'-Dimethyl-4-methoxybenzophenon, Methyl-2-benzoylbenzoat, 4-(2-Hydroxyethylthio)-benzophenon, 4-(4-Tolylthio)benzophenon, 4-Benzoyl-N,N,N-trimethylbenzolmethanaminiumchlorid, 2-Hydroxy-3-(4-benzoylphenoxy)-N,N,N-trimethyl-1-propanaminiumchlorid Monohydrat, 4-(13-Acryloyl-1,4,7,10,13-pentaoxatridecyl)-benzophenon, 4-Benzoyl-N,N-dimethyl-N-[2-(1-oxo-2-propenyl)oxy]ethyl-benzolmethanaminiumchlorid;

### 3. 3-Acylkumarine

3-Benzoylkumarin, 3-Benzoyl-7-methoxykumarin, 3-Benzoyl-5,7-di(propoxy)-kumarin, 3-Benzoyl-6,8-dichlorokumarin, 3-Benzoyl-6-chloro-kumarin, 3,3'-Carbonyl-bis[5,7-di(propoxy)-kumarin], 3,3'-Carbonyl-bis(7-methoxykumarin), 3,3'-Carbonyl-bis(7-diethylamino-kumarin), 3-lsobutyroylkumarin, 3-Benzoyl-5,7-dimethoxy-kumarin, 3-Benzoyl-5,7-diethoxy-kumarin, 3-Benzoyl-5,7-dibutoxy-kumarin, 3-Benzoyl-5,7-di(methoxyethoxy)-kumarin, 3-Benzoyl-5,7-di-(allyloxy)-kumarin, 3-Benzoyl-7-dimethylaminokumarin, 3-Benzoyl-7-diethylaminokumarin, 3-Isobutyroyl-7-dimethylaminokumarin, 5,7-Dimethoxy-3-(1-naphthoyl)-kumarin, 5,7-dimethoxy-3-(1-naphthoyl)-kumarin, 3-Benzoylbenzo[f]kumarin, 7-Diethylamino-3-thienoylkumarin, 3-(4-Cyanobenzoyl)-5,7-dimethoxykumarin;

### 4. 3-(Aroylmethylen)-thiazoline

3-Methyl-2-benzoylmethylen-β-naphthothiazolin, 3-Methyl-2-benzoylmethylen-benzothiazolin, 3-Ethyl-2-propionylmethylen-β-naphthothiazolin;

### 5. Andere Carbonylverbindungen

Acetophenon, 3-Methoxyacetophenon, 4-Phenylacetophenon, Benzil, 2-Acetylnaphthalin, 2-Naphthaldehyd, 9,10-Anthrachinon, 9-Fluorenon, Dibenzosuberon, Xanthon, 2,5-Bis(4-diethylaminobenzyliden)cyclopentanon, α-(Para-dimethylaminobenzyliden)ketone, wie 2-(4-Dimethylamino-benzyliden)-indan-1-on oder 3-(4-Dimethylamino-phenyl)-1-indan-5-yl-propenon, 3-Phenylthiophthalimid, N-Methyl-3,5-di(ethylthio)-phthalimid, N-Methyl-3,5-di(ethylthio)-phthalimid.

Neben diesen für die Lackhärtung wichtigen Additiven können noch weitere Additive in der strahlungshärtbaren Zusammensetzung enthalten sein, insbesondere Lichtschutzmittel.

Die Lacke können bei geeigneter Auswahl der Photoinitiatoren auch pigmentiert sein, dabei können sowohl Buntpigmente als auch Weisspigmente eingesetzt werden.

Die Lacke können in Schichdicken von ca. 1 µm bis ca 100µm aufgebracht werden, vorzugsweise von ca. 1µm bis 40µm. Im Bereich niedriger Schichtdicken < 5µm werden pigmentierte Lacke auch als Druckfarben bezeichnet.

Als Lichtschutzmittel können UV-Absorber, wie z.B. solche vom Hydroxyphenyl-benztriazol-, Hydroxyphenyl-benzophenon-, Oxalsäureamid- oder Hydroxyphenyl-s-triazin-Typ, zugesetzt werden. Es können einzelne oder Mischungen dieser Verbindungen mit oder ohne Einsatz von sterisch gehinderten Aminen (HALS) verwendet werden.

Beispiele für solche UV-Absorber und Lichtschutzmittel sind
1. 2-(2'-Hydroxyphenyl)-benzotriazole, wie z.B. 2-(2'-Hydroxy-5'-methylphenyl)-benzotriazol, 2-(3',5'-Di-tert-butyl-2'-hydroxyphenyl)-benzotriazol, 2-(5'-tert-Butyl-2'-hydroxyphenyl)-benzotriazol, 2-(2'-Hydroxy-5'-(1,1,3,3-tetramethylbutyl)phenyl)-benzotriazol, 2-(3',5'-Di-tert-butyl-2'-hydroxyphenyl)-5-chlor-benzotriazol, 2-(3'-tert-Butyl-2'-hydroxy-5'-methylphenyl)-5-chlorbenzotriazol, 2-(3'-sec-Butyl-5'-tert-butyl-2-hydroxyphenyl)-benzotriazol, 2-(2'-Hydroxy-4'-octoxyphenyl)-benzotriazol, 2-(3',5'-Di-tert-amyl-2'-hydroxyphenyl)-benzotriazol, 2-(3',5'-Bis-(α,α-dimethylbenzyl)-2'-hydroxyphenyl)-benzotriazol, Mischung aus 2-(3'-tert-Butyl-2'-hydroxy-5'-(2-octyloxycarbonylethyl)phenyl)-5-chlor-benzotriazol, 2-(3-tert-Butyl-5'-[2-(2-ethylhexyloxy)-carbonylethyl]-2'-hydroxyphenyl)-5-chlor-benzotriazol, 2-(3'-tert-Butyl-2'-hydroxy-5'-(2-methoxycarbonylethyl)phenyl)-5-chlor-benzotriazol, 2-(3'-tert-Butyl-2'-hydroxy-5'-(2-methoxycarbonylethyl)phenyl)-benzotriazol, 2-(3'-tert-Butyl-2'-hydroxy-5'-(2-octyloxycarbonylethyl)phenyl)-benzotriazol, 2-(3'-tert-Butyl-5'-[2-(2-ethylhexyloxy)carbonylethyl]-2'-hydroxyphenyl)-benzotriazol, 2-(3'-Dodecyl-2'-hydroxy-5'-methylphenyl)-benzotriazol, und 2-(3'tert-Butyl-2'-hydroxy- 5'-(2-isooctyloxycarbonylethyl)phenyl-benzotriazol, 2,2'-Methylen-bis[4-(1,1,3,3-tetramethylbutyl)-6-benzotriazol-2-yl-phenol]; Umesterungsprodukt von 2-[3'-tert-Butyl-5'-(2-methoxycarbonylethyl)-2'-hydroxy-phenyl]-benzotriazol mit Polyethylenglycol 300; [R-CH₂CH₂-COO(CH₂)₃]₂- mit R = 3'-tert-Butyl-4'-hydroxy-5'-2H-benzotriazol-2-yl-phenyl.
2. 2-Hydroxybenzophenone, wie z.B. das 4-Hydroxy-, 4-Methoxy-, 4-Octoxy-, 4-Decyloxy-, 4-Dodecyloxy-, 4-Benzyloxy-, 4,2',4'-Trihydroxy-, 2'-Hydroxy-4,4'-dimethoxy-Derivat.
3. Ester von gegebenenfalls substituierten Benzoesäuren, wie z.B. 4-tert-Butyl-phenylsalicylat, Phenylsalicylat, Octylphenyl-salicylat, Dibenzoylresorcin, Bis-(4-tert-butylbenzoyl)-resorcin, Benzoylresorcin, 3,5-Di-tert-butyl-4-hydroxybenzoesäure-2,4-di-tert-butylphenylester, 3,5-Di-tert-butyl-4-hydroxybenzoesäurehexadecylester, 3,5-Di-tert- butyl-4-hydroxybenzoesäure-octadecylester, 3,5-Di-tert-butyl-4-hydroxybenzoesäure-2-methyl-4,6-di-tert-butylphenylester.
4. Acrylate, wie z.B. α-Cyan-β,β-diphenylacrylsäure-ethylester bzw. -isooctylester, α-Carbomethoxy-zimtsäuremethylester, α-Cyano-β-methyl-p-methoxy-zimtsäuremethylester bzw. -butylester, α-Carbomethoxy-p-methoxy-zimtsäure-methylester, N-(β-Carbomethoxy-β-cyanovinyl)-2-methyl-indolin.
5. Sterisch gehinderte Amine, wie z.B. Bis-(2,2,6,6-tetramethyl-piperidyl)-sebacat, Bis-(2,2,6,6-tetramethyl-piperidyl)-succinat, Bis-(1,2,2,6,6-pentamethylpiperidyl)-sebacat, n-Butyl-3,5-di-tert-butyl-4-hydroxybenzyl-malonsäure-bis(1,2, 2,6,6-pentamethylpiperidyl)-ester, Kondensationsprodukt aus 1-Hydroxyethyl-2,2,6,6-tetramethyl-4-hydroxypiperidin und Bernsteinsäure, Kondensationsprodukt aus N,N'-Bis-(2,2,6,6-Tetramethyl-4-piperidyl)-hexamethylendiamin und 4-tert-Octylamino-2,6-dichlor-1,3,5-s-triazin, Tris-(2,2,6,6-tetramethyl-4-piperidyl)-nitrilotriacetat, Tetrakis-(2,2,6,6-tetramethyl-4-piperidyl)-1,2,3,4-butantetraoat, 1,1'-(1,2-Ethandiyl)-bis-(3,3,5,5-tetramethyl-piperazinon), 4-Benzoyl-2,2,6,6-tetramethylpiperidin, 4-Stearyloxy-2,2,6,6-tetramethylpiperidin, Bis-(1,2,2,6,6-pentamethylpiperidyl)-2-n-butyl-2-(2-hydroxy-3,5-di-tert-butylbenzyl)-malonat, 3-n-Octyl-7,7,9,9-tetramethyl-1,3,8-triazaspiro-[4.5]decan-2,4-dion, Bis-(1-octyloxy-2,2,6,6-tetramethylpiperidyl)-sebacat, Bis-(1-octyloxy-2,2,6,6-tetramethylpiperidyl)-succinat, Kondensationsprodukt aus N,N'-Bis-(2,2,6,6-tetramethyl-4-piperidyl)-hexamethylendiamin und 4-Morpholino-2,6-dichlor-1,3,5-triazin, Kondensationsprodukt aus 2-Chlor-4,6-di-(4-n-butylamino-2,2,6,6-tetramethylpiperidyl)-1,3,5-triazin und 1,2-Bis-(3-aminopropylamino)äthan, Kondensationsprodukt aus 2-Chlor-4,6-di-(4-n-butylamino-1,2,2,6,6-pentamethylpiperidyl)-1,3,5-triazin und 1,2-Bis-(3-aminopropylamino)-äthan, 8-Acetyl-3-dodecyl-7,7,9,9-tetramethyl-1,3,8-triazaspiro[4.5]decan-2,4-dion, 3-Dodecyl-1-(2,2,6,6-tetramethyl-4-piperidyl)pyrrolidin-2,5-dion, 3-Dodecyl-1-(1,2,2,6,6-pentamethyl-4-piperidyl)-pyrrolidin-2,5-dion.
6. Oxalsäurediamide, wie z.B. 4,4'-Di-octyloxy-oxanilid, 2,2'-Diethoxy-oxanilid, 2,2'-Di-octyloxy-5,5'-di-tert-butyl-oxanilid, 2,2'-Di-dodecyloxy-5,5'di-tert-butyl-oxanilid, 2-Ethoxy-2'-ethyloxanilid, N,N'-Bis-(3-dimethylaminopropyl)-oxalamid, 2-Ethoxy-5-tert-butyl-2'-ethyloxanilid und dessen Gemisch mit 2-Ethoxy-2'-ethyl-5,4'-di-tert-butyl-oxanilid, Gemische von o- und p-Methoxy- sowie von o- und p-Ethoxy-di-substituierten Oxaniliden.
7. 2-(2-Hydroxyphenyl)-1,3,5-triazine, wie z.B. 2,4,6-Tris(2-hydroxy-4-octyloxyphenyl)-1,3,5-triazin, 2-(2-Hydroxy-4-octyloxyphenyl)-4,6-bis-(2,4-dimethylphenyl)-1,3,5-triazin, 2-(2,4-Dihydroxyphenyl)-4,6-bis(2,4-dimethylphenyl)-1,3,5-triazin, 2,4-Bis(2-hydroxy-4-propyloxyphenyl)-6-(2,4-dimethylphenyl)-1,3,5-triazin, 2-(2-Hydroxy-4-octyloxyphenyl)-4,6-bis(4-methylphenyl)-1,3,5-triazin, 2-(2-Hydroxy-4-dodecyloxyphenyl)-4,6-bis(2,4-dimethylphenyl)-1,3,5-triazin, 2-[2-hydroxy-4-(2-hydroxy-3-butyloxy-propyloxy)phenyl]-4,6-bis(2,4-dimethylphenyl)-1,3,5-triazin, 2-[2-hydroxy-4-(2-hydroxy-3-octyloxy-propyloxy)phenyl]-4,6-bis(2,4-dimethylphenyl)-1,3,5-triazin, 2-[4-dodecyl/tridecyl-oxy-(2-hydroxypropyl)oxy-2-hydroxyphenyl]-4,6-bis(2,4-dimethylphenyl)-1,3,5-triazin.
   Neben den vorstehend erwähnten Lichtschutzmittel sind auch weitere Stabilisatoren wie Phosphite oder Phosphonite geeignet.
8. Phosphite und Phosphonite, wie z.B. Triphenylphosphit, Diphenylalkylphosphite, Phenyldialkylphosphite, Tris-(nonylphenyl)-phosphit, Trilaurylphosphit, Trioctadecylphosphit, Distearyl-pentaerythritdiphosphit, Tris-(2,4-di-tert-butylphenyl)-phosphit, Diisodecylpentaerythrit-diphosphit, Bis-(2,4-di-tert-butylphenyl)-pentaerythritdiphosphit, Bis-(2,6-di-tert-butyl-4-methylphenyl)-pentaerythritdiphosphit, Bis-isodecyloxy-pentaerythritdiphosphit, Bis-(2,4-di-tert-butyl-6-methylphenyl)-pentaerythritdiphosphit, Bis-(2,4,6-tri-tert-butylphenyl)-pentaerythritdiphosphit, Tristearyl-sorbit-triphosphit, Tetrakis-(2,4-di-tert-butylphenyl)-4,4'-biphenylen-diphosphonit, 6-Isooctyloxy-2,4,8,10-tetra-tert-butyl-12H-dibenz[d,g]-1,3,2-dioxaphosphocin, 6-Fluor-2,4,8,10-tetra-tert-butyl-12-methyl-dibenz[d,g]-1,3,2-dioxaphosphocin, Bis-(2,4-di-tert-butyl-6-methylphenyl)-methylphosphit, Bis-(2,4-di-tert-butyl-6-methylphenyl)-ethylphosphit.

Weiterhin können in der Technik übliche Zusätze, wie beispielsweise Antistatika, Verlaufshilfsmittel und Adhäsionsverbesserer eingesetzt werden.

Wird als fest haftende Schicht eine metallische, metalloxidische oder halbmetalloxidische Schicht aufgebracht, so handelt es sich bevorzugt um folgende Metalle: Gold, Silber, Chrom, Molybdän, Aluminium oder Kupfer, besonders bevorzugt Aluminium und Kupfer. Bevorzugt sind weiter folgende Halbmetall- und Metalloxide: Aluminiumoxid, Chromoxid, Eisenoxid, Kupferoxid und Siliziumoxid.

Die Metalle, Halbmetall- oder Metalloxide werden dabei unter Vakuumbedingungen verdampft und auf dem mit Photoinitiator vorbeschichteten Substrat in Gegenwart von UV-Licht abgeschieden. Die Tiegeltemperaturen für den Verdampfungsprozess hängen vom verwendeten Metall ab und betragen bevorzugt 300 bis 2000° C, besonders bevorzugt 800 bis 1800° C.

Die UV Strahlung während der Abscheidung kann beispielsweise durch einen anodischen Lichtbogen erzeugt werden.

Die metallisch beschichteten Substrate sind geeignet für Diffusionssperrschichten, elektromagnetische Abschirmungen oder sie bilden dekorative Elemente.

Bevorzugt wird der Prozessschritt a) mit einer Niedertemperatur-Plasmaentladung durchgeführt.

Das Verfahren kann in einem weiten Druckbereich ausgeführt werden, wobei sich die Entladungscharakteristik mit zunehmendem Druck vom reinen Niedertemparatur-Plasma in Richtung Corona Entladung verschiebt und schliesslich bei atmosphärischem Druck von ca. 1000-1100mbar in eine reine Corona Entladung übergeht.

Bevorzugt wird das Verfahren bei einem Prozessdruck von 10⁻⁶ mbar bis zu atmosphärischem Druck durchgeführt (1013 mbar), besonders bevorzugt im Bereich von 10⁻⁴ bis 10⁻² mbar als Plasmaverfahren und bei atmosphärischem Druck als Corona-Verfahren.

Bevorzugt wird das Verfahren so durchgeführt, dass als Plasmagas ein Inertgas oder ein Gemisch eines Inertgases mit einem Reaktivgas verwendet wird.

Besonders bevorzugt werden He, Ar, Kr, Xe, N₂, O₂ oder H₂O einzeln oder als Gemisch als Plasmagase verwendet.

Bevorzugt beträgt die Temperatur, bei welcher der Photoinitiator im Vakuum verdampft wird, zwischen 20°C und 250°C, besonders bevorzugt 40° C bis 150° C.

Bevorzugt weist die abgeschiedene Photoinitiatorschicht die Dicke von einer monomolekularen Schicht bis zu 100 nm auf, besonders bevorzugt 10 nm bis 60 nm.

Bevorzugt erfolgt die Plasmabehandlung des anorganischen oder organischen Substrats a) von 1 s bis 300 s, besonders bevorzugt 10 s bis 200 s.

Die Abscheidung des Photoinitiators im Prozessschritt b) erfolgt im Vakuum bevorzugt von 1 s bis 10 Minuten.

Wird eine Corona-Entladung durchgeführt, so wird bevorzugt eine Lösung oder Schmelze des Photoinitiators direkt im Anschluss an die Entladungszone aufgesprüht. Die Corona Entladung kann auch unter Schutzgasatmosphäre durchgeführt werden.

Ist das Substrat mit einer Plasma- oder Corona-Entladung oder durch Bestrahlung mit energiereicher Strahlung vorbehandelt worden, so hängt die Weiterverarbeitungszeit von der Lebensdauer der gebildeten Radikale auf der Oberfläche ab. Grundsätzlich gilt, dass es vorteilhaft ist so rasch wie möglich den Photoinitiator aufzubringen, da am Anfang eine hohe Zahl reaktiver Radikale an der Oberfläche für die Pfropfreaktion vorliegen. Für viele Zwecke kann es aber auch akzeptabel sein, den Reaktionsschritt b) mit einer zeitlichen Verzögerung durchzuführen. Bevorzugt jedoch wird der Verfahrensschritt b) unmittelbar oder innerhalb von 10 Stunden nach dem Verfahrensschritt a) durchgeführt wird.

Ein weiterer Gegenstand der Erfindung ist die Verwendung von Photoinitiatoren, enthaltend eine oder mehrere ethylenisch ungesättigte Gruppen, zur Herstellung haftfester Beschichtungen auf einem anorganischen oder organischen Substrat, dadurch gekennzeichnet, dass man in einem ersten Schritt
a) auf das anorganische oder organische Substrat eine Niedertemperatur-Plasmaentladung, eine Corona-Entladung, energiereiche UV-Strahlung oder Elektronenstrahlung einwirken lässt, anschliessend die Strahlung oder Entladung abschaltet, in einem weiteren Schritt
b) einen oder mehrere Photoinitiatoren, enthaltend mindestens eine ethylenisch ungesättigte Gruppe, unter Vakuum oder bei Normaldruck auf das anorganische oder organische Substrat aufbringt und mit den dort entstandenen Radikalstellen reagieren lässt, und
c1) das so mit Photoinitiator vorbeschichtete Substrat mit einer Zusammensetzung, enthaltend mindestens ein ethylenisch ungesättigtes Monomer oder Oligomer, beschichtet und die Beschichtung mittels UVNIS Strahlung härtet oder
c2) auf das so mit Photoinitiator vorbeschichtete Substrat ein Metall, Halbmetall- oder Metalloxid aus der Gasphase in Gegenwart von UV-Licht abscheidet.

Ebenfalls Gegenstand der Erfindung sind haftfeste Beschichtungen, erhältlich nach dem vorstehend beschriebenen Verfahren.

Derartige haftfeste Beschichtungen sind sowohl als Schutzschichten oder Überzugsmittel von Bedeutung, wobei diese noch zusätzlich pigmentiert sein können, als auch für abbildende Beschichtungen, wie zum Beispiel in der Resisttechnologie.

Die nachstehenden Beispiele erläutern die Erfindung.

### Beispiel 1

Die Plasmabehandlung erfolgt in einem handelsüblichen Parallelplattenreaktor bei 40 kHz . Als Substrat wird eine 3 mm dickes Serien-Kunststoffbauteil aus PP/EPDM verwendet dessen eine Hälfte hart und die andere weich modifiziert ist.
Ein solches Substrat wird bei 3•10⁻² mbar für 20 Sekunden einem Argon Plasma, ein weiteres Substrat einem Argon/O₂ Plasma (75/25) unterzogen, wobei die Substrate jeweils auf einem Halter so angeordnet sind, dass nur eine Seite dem Plasma ausgesetzt wird. Das Plasma wird abgeschaltet und der Druck auf 2•10⁻⁴ mbar abgesenkt. In der Plasmakammer wird in einem heizbaren Tiegel der Photoinitiator der nachstehend aufgeführten Strukturformel 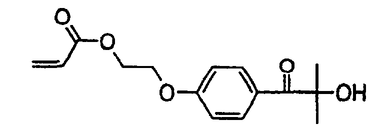 bei 50-52° C in 180 Sekunden verdampft, wobei eine Schichtdicke von ca. 30 nm erreicht wird. Die Dickenmessung erfolgt mittels eines handelsüblichen Schwingquarzes.

Das so vorbeschichtete Substrat wird in eine strahlungshärtbare Epoxyacrylat-Zusammensetzung aus 89% Ebecryl® 604 (UCB), 10% SR® 344 (Sartomer), 1% Ebecryl® 350 (UCB) und 2% Darocur® 1173 (Ciba Spezialitätenchemie) getaucht.

Die getauchten Proben werden in einem Prozessor der Fa. AETEK mit zwei 80W/cm² Quecksilbermitteldruck-Lampen bei einer Bandgeschwindigkeit von 3m/min nacheinander beidseitig gehärtet.

Die Haftfestigkeit wird mittels Gitterschnitt und Klebebandabriss bestimmt.

Bei beiden Proben erfolgt an der Unterseite, die keine Photoinitiatorschicht aufweist ein vollständiger Abriss der Lackierung.

Auf der mit Photoinitiator vorbehandelten Seite werden nur minimale Splitter an den Kreuzschnitten abgelöst, die Haftung auf dem weichen und harten Segment der Proben ist gleich gut. Die Probe, welche einem Argon/O₂ Plasma unterzogen wurde, weist ein leicht besseres Haftungsresultat auf.

Nach 10 Tagen Belichtung am Sonnenlicht bleiben die hervorragenden Haftwerte erhalten.

### Beispiel 2

Als Substrat wird eine 1 mm dicke Teflon® Folie verwendet. Plasmabedingungen und Photoinitiator entsprechen Beispiel 1. Die Lackzusammensetzung aus Beispiel 1 wird in 30µm Dicke aufgerakelt.

Bei beiden Proben erfolgt an der Unterseite, die keine Photoinitiatorschicht aufweist ein vollständiger Abriss der Lackierung.

Auf der mit Photoinitiator vorbehandelten Seite werden nur minimale Splitter an den Kreuzungsschnitten abgelöst, die Haftung ist ausgezeichnet. Die Probe, welche einem Argon/O₂ Plasma unterzogen wurde, weist ein leicht besseres Haftungsresultat auf.

### Beispiel 3 Kupferbeschichtung auf PTFE

Als Substrat wird eine 5mm dicke Teflon® Folie verwendet. Plasmabedingungen und Photoinitiator entsprechen Beispiel 1

Nach Auftrag der Photoinitiatorschicht wird im selben Reaktor eine Cu-Schicht in einem anodischen Lichtbogenverfahren (VALICO-Verfahren) bei einem Druck von 2•10⁻⁴ mbar abgeschieden. Die Tiegeltemperatur beträgt 1500-1600° C. Innerhalb einer Minute wird dabei eine Schicht von 1µm Schichtdicke abgeschieden.

Die Kupferschicht lässt sich vom Substrat durch einen Abrisstest mittels Klebeband nicht mehr ablösen.

### Beispiel 4. Vorbehandlung mit Vakuum UV.

In einer Vakuumkammer werden unterschiedliche Polymerfolien mit kurzwelligem UV Licht mit einer Wellenlänge von 172 nm während 2 Minuten bestrahlt. Zur Bestrahlung wird eine Excimerlampe (Excivac® der Fa. Heraeus Nobellight, Kleinostheim) verwendet und der Druck in der Kammer beträgt 3*10⁻² mbar. Bei der Belichtung mit der Excimerstrahlung wird eine Hälfte der Folie mit einer Aluminiumfolie beidseitig bedeckt, so daß dort keine Radikale erzeugt werden. Nach der Beendigung der Belichtung wird der Druck auf 8*10⁻⁴ mbar abgesenkt und in einem heizbaren Tiegel der Photoinitiator aus Beispiel 1 bei einer Temperatur von bis zu 120 °C während 2 Minuten verdampft.
Die beschichteten Substrate werden mit der strahlungshärtbaren Formulierung aus Beispiel 1 mittels Pinselauftrag beschichtet. Diese Proben werden in einem Prozessor der Fa.
AETEK mit zwei 80W/cm² Quecksilbermitteldruck-Lampen bei einer Bandgeschwindigkeit von 10 m/min. gehärtet. Die Haftfestigkeit wird mittels Gitterschnitt bestimmt.
Im Falle einer Polypropylenfolie als Substrat wird auf dem belichteten und bedampften Bereich eine leicht erhöhte Haftung des Lackfilms erzielt, während auf der unbelichteten und unbedampften Seite keine Haftung erzielt wird. Ebenfalls keine Haftung wird auf Folien erreicht, die nur belichtet werden.
Im Falle einer Polyesterfolie (Mylar® DuPont, 100 µm) als Substrat wird auf dem belichteten und bedampften Bereich eine sehr gute Haftung des Lackfilms erzielt (die Schicht lässt sich nicht mehr abtrennen), während auf dem unbehandelte Bereich der Lack einfach abgezogen werden kann. Auf nur belichteten Filmen wird eine unwesentlich erhöhte Haftung erzielt.

## Patentansprüche

1. Verfahren zur Herstellung haftfester Beschichtungen auf einem anorganischen oder organischen Substrat, **dadurch gekennzeichnet, dass** man in einem ersten Schritt
a) auf das anorganische oder organische Substrat eine Niedertemperatur-Plasmaentladung, eine Corona-Entladung, energiereiche UV-Strahlung oder Elektronenstrahlung einwirken lässt, anschliessend die Strahlung oder Entladung abschaltet, in einem weiteren Schritt
b) einen oder mehrere Photoinitiatoren, enthaltend mindestens eine ethylenisch ungesättigte Gruppe, unter Vakuum oder bei Normaldruck auf das anorganische oder organische Substrat aufbringt und mit den dort entstandenen Radikalstellen reagieren lässt, und
c1) das so mit Photoinitiator vorbeschichtete Substrat mit einer Zusammensetzung, enthaltend mindestens ein ethylenisch ungesättigtes Monomer oder Oligomer, beschichtet und die Beschichtung mittels UV/VIS Strahlung härtet oder
c2) auf das so mit Photoinitiator vorbeschichtete Substrat ein Metall, Halbmetall- oder Metalloxid aus der Gasphase in Gegenwart von UV-Licht abscheidet.

2. Verfahren nach Anspruch 1, **dadurch gekennzeichnet, dass** das anorganische oder organische Substrat in Form eines Pulvers, einer Faser, einer Folie oder als dreidimensionales Werkstück vorliegt.

3. Verfahren nach Anspruch 1, **dadurch gekennzeichnet, dass** das anorganische oder organische Substrat ein thermoplastisches, elastomeres, strukturvernetztes oder vemetztes Polymer, ein Metalloxid, ein Glas oder ein Metall ist.

4. Verfahren nach Anspruch 1, **dadurch gekennzeichnet, dass** der Photoinitiator eine Verbindung der Formel I oder la ist
(RG)-A-(IN) (I),
(IN)-A-(RG')-A-(IN) (Ia),
worin
(IN) eine Photoinitiatorgrundstruktur ist,
A für eine Spacergruppe oder eine Einfachbindung steht,
(RG) mindestens eine funktionelle ethylenisch ungesättigte Gruppe bedeutet, und
(RG') für einen zweiwertigen Rest, der mindestens eine funktionelle ethylenisch ungesättigte Gruppe enthält, steht.

5. Verfahren nach Anspruch 4, worin in den Verbindungen der Formel I oder la
(IN) eine Photoinitiatorgrundstruktur der Formel (II) oder (III) ist 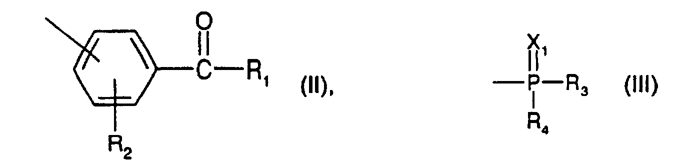
R₁ eine Gruppe (A), (B) oder (III) darstellt 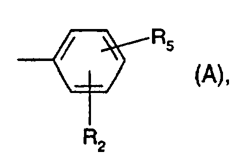
-CR₆R₇R₈ (B);
R₂ für Wasserstoff, C₁-C₁₂-Alkyl, Halogen, die Gruppe (RG)-A- oder, falls R₁ für eine Gruppe (A) steht, zwei zur Carbonylgruppe orthoständige Reste R₂ zusammen auch für -S- oder 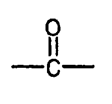 stehen können;
R₃ und R₄ unabhängig voneinander C₁-C₆-Alkyl, C₁-C₆-Alkanoyl, Phenyl oder Benzoyl ist, wobei die Reste Phenyl oder Benzoyl, jeweils gegebenenfalls mit Halogen, C₁-C₆-Alkyl, C₁-C₆-Alkylthio oder C₁-C₆-Alkoxy substituiert sind;
R₅ Wasserstoff, Halogen, C₁-C₁₂-Alkyl oder C₁-C₁₂-Alkoxy oder die Gruppe (RG)-A-bedeutet;
R₆ OR₉ oder N(R₉)₂ ist oder für 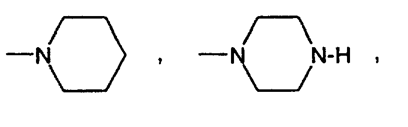 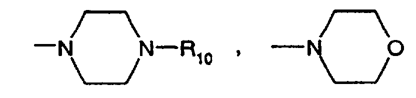 oder SO₂R₉ steht;
R₇ und R₈ jeweils unabhängig voneinander H, C₁-C₁₂-Alkyl, C₂-C₁₂-Alkenyl, C₁-C₁₂-Alkoxy, Phenyl, Benzyl oder zusammen C₂-C₆-Alkylen sind;
R₉ Wasserstoff, C₁-C₆-Alkyl oder C₁-C₆-Alkanoyl ist;
R₁₀ Wasserstoff, C₁-C₁₂-Alkyl oder Phenyl ist; und
X₁ Sauerstoff oder Schwefel bedeutet.

6. Verfahren nach Anspruch 4, worin in den Verbindungen der Formel I oder la (IN) eine Gruppe 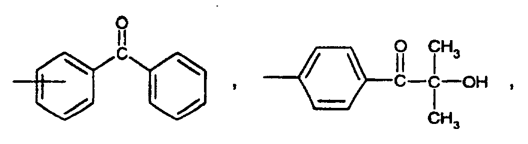 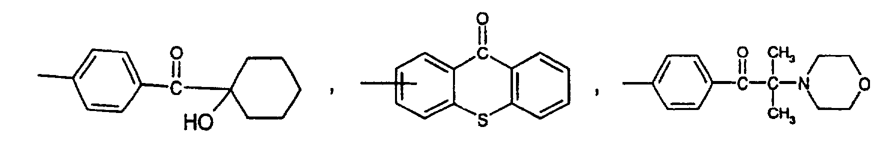 oder 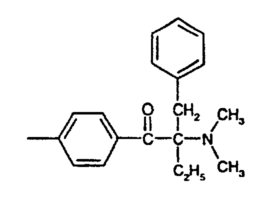 ist.

7. Verfahren nach Anspruch 4, worin in den Verbindungen der Formel I oder la
A für eine Spacergruppe -Z-[(A₁)ₐ-Y]_{c}-[(A₂)_{b}-X]_{d} steht;
X, Y und Z jeweils unabhängig voneinander für eine Einfachbindung, -O-, -S- ,-N(R₁₀)-, -(CO)-, -(CO)O-, -(CO)N(R₁₀)-, -O-(CO)-, -N(R₁₀)-(CO)- oder -N(R₁₀)-(CO)O- stehen;
A₁ und A₂ unabhängig voneinander C₁-C₄-Alkylen, C₃-C₁₂-Cycloalkylen, Phenylen, Phenylen-C₁-C₄-Alkylen oder C₁-C₄-Alkylen-Phenylen-C₁-C₄-Alkylen bedeuten;
a, b, c und d unabhängig voneinander für die Zahlen 0 bis 4 stehen; und
R₁₀ wie vorstehend definiert ist.

8. Verfahren nach Anspruch 7, worin in den Verbindungen der Formel I oder la A eine Spacergruppe -Z-[(CH₂)ₐ-Y]_{c}-[(CH₂)_{b}-X]_{d}- ist, worin X, Y, Z, a,b,c und d die vorstehend angegebenen Bedeutungen haben.

9. Verfahren nach Anspruch 4, worin in den Verbindungen der Formel I oder la
(RG) für R_{c}R_{b}C=CRₐ- steht,
(RG') 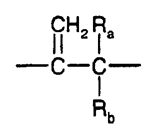 ist , und
Rₐ, R_{b}, R_{c} jeweils H oder C₁-C₆-Alkyl, insbesondere H oder CH₃, bedeuten.

10. Verfahren nach Anspruch 1, **dadurch gekennzeichnet, dass** mindestens eines der ethylenisch ungesättigten Monomeren oder Oligomeren der Zusammensetzung ein mono-, di-, tri- oder tetra-funktionelles Acrylat oder Methacrylat ist.

11. Verfahren nach Anspruch 1, **dadurch gekennzeichnet, dass** die Zusammensetzung, enthaltend mindestens ein ethylenisch ungesättigtes Monomer oder Oligomer, mindestens einen weiteren Photoinitiator oder Coinitiator für die Härtung mit UV/VIS Strahlung enthält.

12. Verfahren nach Anspruch 1, **dadurch gekennzeichnet, dass** der Prozessdruck von 10⁻⁶ mbar bis atmosphärischem Druck beträgt.

13. Verfahren nach Anspruch 1, **dadurch gekennzeichnet, dass** als Plasmagas ein Inertgas oder ein Gemisch eines inertgases mit einem Reaktivgas verwendet wird.

14. Verfahren nach Anspruch 13, **dadurch gekennzeichnet, dass** N₂, He, Ar, Kr, Xe, O₂ oder H₂O einzeln oder als Gemisch verwendet werden.

15. Verfahren nach Anspruch 1, **dadurch gekennzeichnet, dass** die Temperatur, bei welcher der Photoinitiator verdampft wird, zwischen 20°C und 250°C beträgt.

16. Verfahren nach Anspruch 1, **dadurch gekennzeichnet, dass** die abgeschiedene Photoinitiatorschicht oder die Metallschicht die Dicke von einer monomolekularen Schicht bis zu 100 nm aufweist.

17. Verfahren nach Anspruch 1, **dadurch gekennzeichnet, dass** die Plasmabehandlung a) von 1 s bis 300 s erfolgt.

18. Verfahren nach Anspruch 1, **dadurch gekennzeichnet, dass** die Abscheidung des Photoinitiators b) von 1 s bis 10 Min. erfolgt

19. Verfahren nach Anspruch 1, **dadurch gekennzeichnet, dass** der Verfahrensschritt b) unmittelbar oder innerhalb von 10 Stunden nach dem Verfahrensschritt a) durchgeführt wird.

20. Verwendung von Photoinitiatoren, enthaltend eine oder mehrere ethylenisch ungesättigte Gruppen, zur Herstellung haftfester Beschichtungen auf einem anorganischen oder organischen Substrat, **dadurch gekennzeichnet, dass** man in einem ersten Schritt
a) auf das anorganische oder organische Substrat eine Niedertemperatur-Plasmaentladung, eine Corona-Entladung, energiereiche UV-Strahlung oder Elektronenstrahlung einwirken lässt, anschliessend die Strahlung oder Entladung abschaltet, in einem weiteren Schritt
b) einen oder mehrere Photoinitiatoren, enthaltend mindestens eine ethylenisch ungesättigte Gruppe, unter Vakuum oder bei Normaldruck auf das anorganische oder organische Substrat aufbringt und mit den dort entstandenen Radikalstellen reagieren lässt, und
c1) das so mit Photoinitiator vorbeschichtete Substrat mit einer Zusammensetzung, enthaltend mindestens ein ethylenisch ungesättigtes Monomer oder Oligomer, beschichtet und die Beschichtung mittels UV/VIS Strahlung härtet oder
c2) auf das so mit Photoinitiator vorbeschichtete Substrat ein Metall, Halbmetall- oder Metalloxid aus der Gasphase in Gegenwart von UV-Licht abscheidet.

21. Haftfeste Beschichtungen, erhältlich nach einem Verfahren gemäss Anspruch 1.

## Claims

1. A process for the production of strongly adherent coatings on an inorganic or organic substrate that comprises in a first step
a) subjecting the inorganic or organic substrate to the action of a low-temperature plasma discharge, a corona discharge, high-energy UV radiation or electron radiation, then discontinuing the radiation or discharge; in a further step
b) under vacuum or at normal pressure, applying one or more photoinitiators containing at least one ethylenically unsaturated group to the inorganic or organic substrate, and allowing reaction with the free-radical sites formed there; and
c1) coating the substrate so precoated with photoinitiator with a composition comprising at least one ethylenically unsaturated monomer or oligomer, and curing the coating by means of UV/VIS radiation or
c2) depositing a metal, semi-metal oxide or metal oxide from the gaseous phase, in the presence of UV light, on the substrate so precoated with photoinitiator.

2. A process according to claim 1, wherein the inorganic or organic substrate is in the form of a powder, a fibre, a film or a three-dimensional workpiece.

3. A process according to claim 1, wherein the inorganic or organic substrate is a thermoplastic, elastomeric, inherently crosslinked or crosslinked polymer, a metal oxide, a glass or a metal.

4. A process according to claim 1, wherein the photoinitiator is a compound of formula I or Ia
(RG)-A-(IN) (I),
(IN)-A-(RG')-A-(IN) (Ia),
wherein
(IN) is a photoinitiator base structure,
A is a spacer group or a single bond,
(RG) denotes at least one functional ethylenically unsaturated group, and
(RG') is a divalent radical that contains at least one functional ethylenically unsaturated group.

5. A process according to claim 4, wherein in the compounds of formula I or Ia
(IN) is a photoinitiator base structure of formula (II) or (III) 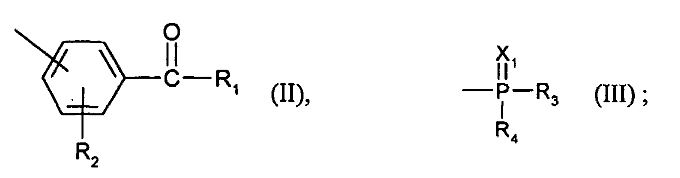
R, is a group (A), (B) or (III) 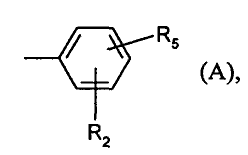
-CR₆R₇R₈ (B);
R₂ is hydrogen, C₁-C₁₂alkyl, halogen, the group (RG)-A- or, when R₁ is a group (A), two R₂ radicals in the ortho position relative to the carbonyl group may together also denote -S- or 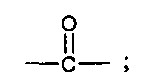
R₃ and R₄ are each independently of the other C₁-C₆alkyl, C₁-C₆alkanoyl, phenyl or benzoyl, wherein the radicals phenyl or benzoyl are each unsubstituted or substituted by halogen, C₁-C₆alkyl, C₁-C₆alkylthio or by C₁-C₆alkoxy;
R₅ is hydrogen, halogen, C₁-C₁₂alkyl or C₁-C₁₂alkoxy or the group (RG)-A-;
R₆ is OR₉ or N(R₉)₂ or 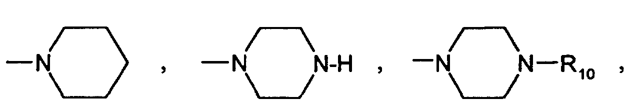 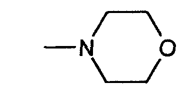 or SO₂R₉ ;
R₇ and R₈ are each independently of the other H, C₁-C₁₂alkyl, C₂-C₁₂alkenyl, C₁-C₁₂alkoxy, phenyl or benzyl or together are C₂-C₆alkylene;
R₉ is hydrogen, C₁-C₆alkyl or C₁-C₆alkanoyl;
R₁₀ is hydrogen, C₁-C₁₂alkyl or phenyl; and
X, is oxygen or sulfur.

6. A process according to claim 4, wherein in the compounds of formula I or Ia
(IN) is a group 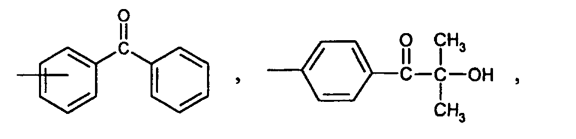 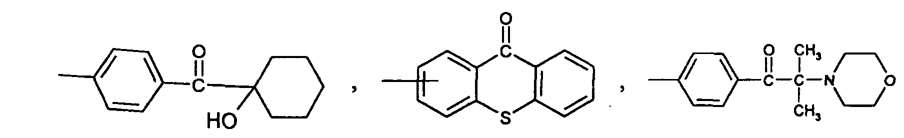 or

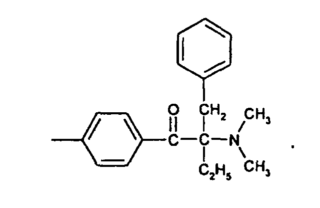

7. A process according to claim 4, wherein in the compounds of formula I or Ia
A is a spacer group -Z-[(A₁)ₐ-Y]_{c}-[(A₂)_{b}-X]_{d};
X, Y and Z are each independently of any other(s) a single bond, -O-, -S-, -N(R₁₀)-, -(CO)-, -(CO)O-, -(CO)N(R₁₀)-, -O-(CO)-, -N(R₁₀)-(CO)- or -N(R₁₀)-(CO)O-;
A₁ and A₂ are each independently of any other(s) C₁-C₄alkylene, C₃-C₁₂cycloalkylene, phenylene, phenylene-C₁-C₄alkylene or C₁-C₄alkylenephenylene-C₁-C₄alkylene;
a, b, c and d are each independently of the others a number from 0 to 4; and
R₁₀ is as defined hereinbefore.

8. A process according to claim 7, wherein in the compounds of formula I or Ia A is a spacer group -Z-[(CH₂)ₐ-Y]_{c}-[(CH₂)_{b}-X]_{d}- in which X, Y, Z, a, b, c and d are as defined hereinbefore.

9. A process according to claim 4, wherein in the compounds of formula I or Ia
(RG) is R_{c}R_{b}C=CRₐ- ,
(RG') is 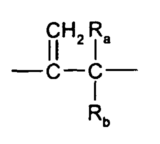 and
Rₐ, R_{b} and R_{c} are each H or C₁-C₆alkyl, especially H or CH₃.

10. A process according to claim 1, wherein at least one of the ethylenically unsaturated monomers or oligomers of the composition is a mono-, di-, tri- or tetra-functional acrylate or methacrylate.

11. A process according to claim 1, wherein the composition comprising at least one ethylenically unsaturated monomer or oligomer comprises at least one further photoinitiator or coinitiator for the curing by UV/VIS radiation.

12. A process according to claim 1, wherein the process pressure is from 10⁻⁶ mbar up to atmospheric pressure.

13. A process according to claim 1, wherein there is used as plasma gas an inert gas or a mixture of an inert gas with a reactive gas.

14. A process according to claim 13, wherein N₂, He, Ar, Kr, Xe, O₂ and H₂O are used on their own or in the form a mixture.

15. A process according to claim 1, wherein the temperature at which the photoinitiator is vaporised is from 20°C to 250°C.

16. A process according to claim 1, wherein the deposited photoinitiator layer or the metal layer has a thickness ranging from that of a monomolecular layer up to 100 nm.

17. A process according to claim 1, wherein the plasma treatment a) is carried out for from 1 second to 300 seconds.

18. A process according to claim 1, wherein the deposition of the photoinitiator b) is carried out for from 1 second to 10 minutes.

19. A process according to claim 1, wherein process step b) is carried out immediately after, or within 10 hours of, process step a).

20. The use of a photoinitiator containing one or more ethylenically unsaturated groups in the production of strongly adherent coatings on an inorganic or organic substrate that comprises in a first step
a) subjecting the inorganic or organic substrate to the action of a low-temperature plasma discharge, a corona discharge, high-energy UV radiation or electron radiation, then discontinuing the radiation or discharge; in a further step
b) under vacuum or at normal pressure, applying one or more photoinitiators containing at least one ethylenically unsaturated group to the inorganic or organic substrate, and allowing reaction with the free-radical sites formed there; and
c1) coating the substrate so precoated with photoinitiator with a composition comprising at least one ethylenically unsaturated monomer or oligomer, and curing the coating by means of UV/VIS radiation or
c2) depositing a metal, semi-metal oxide or metal oxide from the gaseous phase, in the presence of UV light, on the substrate so precoated with photoinitiator.

21. A strongly adherent coating obtainable in accordance with a process according to claim 1.

## Revendications

1. Procédé pour la préparation de revêtements adhérents sur des substrats organiques ou inorganiques, **caractérisés en ce que**, dans une première étape,
a) on laisse agir sur le substrat organique ou inorganique une décharge de plasma à basses températures, une décharge corona, un rayonnement UV riche en énergie ou un faisceau d'électrons, ensuite on coupe l'irradiation ou la décharge, dans une étape suivante,
b) on applique un ou plusieurs photoamorceurs, contenant au moins un groupe à insaturation éthylénique, sous vide ou à la pression normale, au substrat organique ou inorganique et on laisse réagir avec les sites radicalaires formés, et
c1) on revêt le substrat, pré-revêtu de cette façon du photoamorceur, d'une composition contenant au moins un monomère ou oligomère à insaturation éthylénique, et on durcit le revêtement par un rayonnement UV/VIS ou
c2) on dépose sur le substrat, pré-revêtu du photoamorceur, un métal, un oxyde métalloïde ou métallique en phase gazeuse en présence de rayonnement UV.

2. Procédé selon la revendication 1, **caractérisé en ce que** le substrat inorganique ou organique se présente sous forme d'une poudre, d'une fibre, d'une feuille ou comme pièce de fabrication tridimensionnelle.

3. Procédé selon la revendication 1, **caractérisé en ce que** le substrat inorganique ou organique est un élastomère, un polymère réticulé ou une structure composite réticulé, un oxyde métallique, un verre ou un métal.

4. Procédé selon la revendication 1, **caractérisé en ce que** le photoamorceur est un composé de formule I ou Ia
**(RG)-A-(IN) (I)**
**(IN)-A-(RG')-A-(IN) (Ia)**
où
(IN) est une structure de base de photoamorceur,
A représente un groupe espaceur ou une liaison simple,
(RG) représente au moins un groupe fonctionnel à insaturation éthylénique, et
(RG') représente un reste bivalent, qui présente au moins un groupe à insaturation éthylénique.

5. Procédé selon la revendication 4, où dans les composés de formule I ou Ia
(IN) est une structure de base de photoamorceur de formule (II) ou (III), 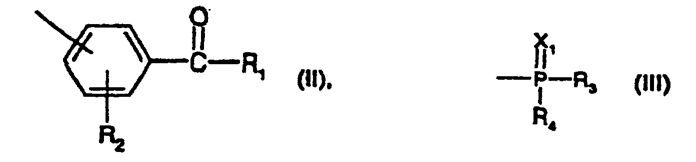
R₁ représente un groupe (A), (B) ou (III) 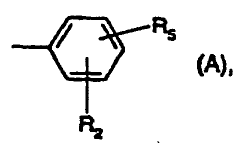
**-CR**_{**6**}**R**_{**7**}**R**_{**8**} **(B);**
R₂ représente un atome d'hydrogène, un groupe alkyle en C₁-C₁₂, halogène, le groupe (RG)-A- ou, dans le cas oùR₁ représente un groupe (A), deux restes R₂ en position ortho au groupe carbonyle peuvent représenter aussi -S- ou 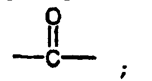
R₃ et R₄ indépendamment l'un de l'autre représentent un groupe alkyle en C₁-C₆, alcanoyle en C₁-C₆, phényle ou benzoyle, les restes phényle ou benzoyle, substitué chacun éventuellement par un substituant halogène, alkyle en C₁-C₆, (alkyl en C₁-C₆)thio ou alkoxy en C₁-C₆ ;
R₅ représente un atome d'hydrogène, un atome d'halogène, un groupe alkyle en C₁-C₁₂ ou alkoxy en C₁-C₁₂ ou le groupe (RG)-A- ;
R₆ représente un groupe OR₉ ou N(R₉)₂ ou 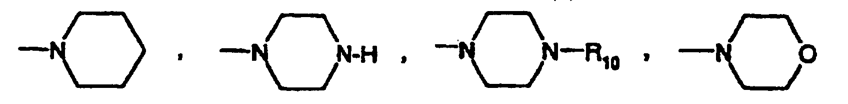 ou SO₂R₉ ;
R₇ et R₈ représentent chacun indépendamment l'un de l'autre un atome d'hydrogène, un groupe alkyle en C₁-C₁₂, alcényle en C₂-C₁₂, alkoxy en C₁-C₁₂, phényle, benzyle ou ensemble un groupe alkylène en C₂-C₁₂ ;
R₉ représente un atome d'hydrogène, un groupe alkyle en C₁-C₆ ou alcanoyle en C₁-C₆ ;
R₁₀ représente un atome d'hydrogène, un groupe alkyle en C₁-C₆ ou phényle ; et
X₁ représente un atome d'oxygène ou de soufre.

6. Procédé selon la revendication 4, où dans les composés de formule I ou Ia
(IN) représente un groupe 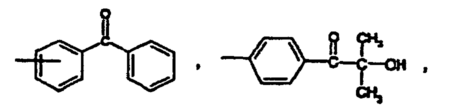 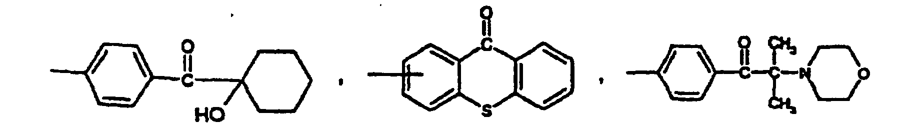 ou

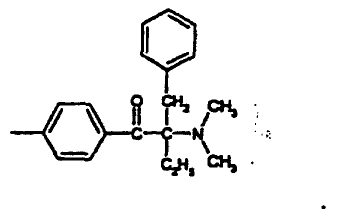

7. Procédé selon la revendication 4, où dans les composés de formule I ou Ia
A représente un groupe espaceur -Z-[(A₁)ₐ-Y]_{c}-[(A₂)_{b}-X]_{d} ;
X, Y et Z chacun indépendamment l'un de l'autre représentent une simple liaison, -O-, -S-, -N(R₁₀)-, -(CO)-, -(CO)O-, -(CO)N(R₁₀)-, -O-(CO)-, -N(R₁₀)-(CO)- ou -N(R₁₀)-(CO)O- ;
A₁ et A₂ indépendamment l'un de l'autre représentent un groupe alkylène en C₁-C₄, cycloalkylène en C₃-C₁₂, phénylène, phénylénalkylène en C₁-C₄ ou (alkylène en C₁-C₄)-phénylénalkylène en C₁-C₄ ;
a, b, c et d vont indépendamment de 0 à 4 ; et
R₁₀ est défini comme auparavant.

8. Procédé selon la revendication 7, où dans les composés de formule I ou Ia, A représente un groupe espaceur -Z-[(CH₂)ₐ-Y]_{c}-[(CH₂)_{b}-X]_{d}-, où X, Y, Z, a, b, c et d possèdent les significations données auparavant.

9. Procédé selon la revendication 4, où dans les composés de formule I ou Ia
(RG) représente R_{c}R_{b}C=CRₐ-,
(RG') représente 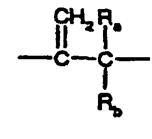 et
Rₐ, R_{b}, R_{c} représentent chacun un atome d'hydrogène ou un groupe alkyle en C₁-C₆, en particulier un atome d'hydrogène ou CH₃.

10. Procédé selon la revendication 1, **caractérisé en ce que**, au moins un des monomères ou oligomères à insaturation éthylénique de la composition est un acrylate ou méthacrylate mono-, di-, tri- ou tétrafonctionnel.

11. Procédé selon la revendication 1, **caractérisé en ce que** la composition, renfermant au moins un monomère ou oligomère à insaturation éthylénique, renferme au moins un autre photoamorceur ou co-amorceur pour le durcissement par un rayonnement UV/VIS.

12. Procédé selon la revendication 1, **caractérisé en ce que** la pression du procédé est de 10⁻⁶ mbars à la pression atmosphérique.

13. Procédé selon la revendication 1, **caractérisé en ce qu'**on utilise comme gaz de plasma un gaz inerte ou un mélange d'un gaz inerte dans un gaz réactif.

14. Procédé selon la revendication 13, **caractérisé en ce qu'**on utilise N₂, He, Ar, Kr, Xe, O₂ ou H₂O seuls ou en mélange.

15. Procédé selon la revendication 1, **caractérisé en ce que** la température à laquelle on vaporise le photoamorceur est comprise entre 20°C et 250°C.

16. Procédé selon la revendication 1, **caractérisé en ce que** la couche de photoamorceur déposée ou la couche métallique présente une épaisseur allant d'une couche monomoléculaire à 100 nm.

17. Procédé selon la revendication 1, **caractérisé en ce que** le traitement au plasma a) est mis en oeuvre pendant une durée de 1 seconde à 300 secondes.

18. Procédé selon la revendication 1, **caractérisé en ce qu'**on réalise le dépôt du photoamorceur b) pendant une durée de 1 s à 10 minutes.

19. Procédé selon la revendication 1, **caractérisé en ce qu'**on met en oeuvre l'étape de procédé b) directement ou en l'espace de 10 heures après le dépôt.

20. Utilisation de photoamorceurs, renfermant un ou plusieurs groupes à insaturation éthylénique, pour la préparation de revêtement solidement adhérents à un substrat organique ou inorganique, **caractérisé en ce que**, dans une première étape a), on applique au substrat inorganique ou organique une décharge plasmatique à basse température, une décharge corona, un rayonnement UV riche en énergie ou des faisceaux d'électrons, ensuite on coupe la source de rayonnement ou la production de décharge, dans une autre étape b), on applique sous vide ou à la pression normale un ou plusieurs photoamorceurs renfermant au moins un groupe à insaturation éthylénique, et on laisse réagir avec les sites radicalaires formés et c1), on revêt le substrat, prérevêtu du photoamorceur, d'une composition renfermant au moins un monomère ou oligomère à insaturation éthylénique, et on durcit le revêtement par un rayonnement UV/VIS ou c2), on dépose sur le substrat pré-revêtu du photoamorceur un métal, un oxyde métallique ou de métalloïde, en phase gazeuse en présence de rayonnement UV.

21. Revêtements solidement adhérents que l'on peut préparer au moyen d'un procédé selon la revendication 1.
